(19) Europäisches Patentamt

European Patent Office

Office européen des brevets

(11) **EP 3 707 522 B1**

(12) **FASCICULE DE BREVET EUROPEEN**

(45) Date de publication et mention de la délivrance du brevet:
**20.10.2021 Bulletin 2021/42**

(21) Numéro de dépôt: **18804372.3**

(22) Date de dépôt: **06.11.2018**

(51) Int Cl.:
*G01R 33/022* (2006.01)    *G01R 33/028* (2006.01)

(86) Numéro de dépôt international:
**PCT/FR2018/052726**

(87) Numéro de publication internationale:
**WO 2019/092348 (16.05.2019 Gazette 2019/20)**

(54) **CAPTEUR DE GRADIENT DE CHAMP MAGNÉTIQUE A SENSIBILITÉ AUX VIBRATIONS RÉDUITE**

MAGNETFELDGRADIENTENSENSOR MIT REDUIZIERTER EMPFINDLICHKEIT GEGEN VIBRATION

MAGNETIC FIELD GRADIENT SENSOR WITH REDUCED VIBRATIONS SENSITIVITY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **08.11.2017 FR 1760494**

(43) Date de publication de la demande:
**16.09.2020 Bulletin 2020/38**

(73) Titulaire: **Commissariat à l'Énergie Atomique et aux Énergies Alternatives 75015 Paris (FR)**

(72) Inventeurs:
• JOURDAN, Guillaume
  38000 Grenoble (FR)
• DELAET, Bertrand
  38190 Bernin (FR)
• JOET, Loïc
  38640 Claix (FR)

(74) Mandataire: **Brevalex 95, rue d'Amsterdam 75378 Paris Cedex 8 (FR)**

(56) Documents cités:
EP-A2- 1 306 350     WO-A1-2015/058229
US-A1- 2007 096 729     US-A1- 2012 176 129

**Description**

## DOMAINE TECHNIQUE ET ÉTAT DE LA TECHNIQUE ANTÉRIEURE

La présente invention se rapporte à un capteur de gradient de champ magnétique offrant une sensibilité réduite aux vibrations.

Les capteurs de gradient de champ magnétique peuvent par exemple être utilisés dans la détection de la position angulaire d'un arbre à came ou d'un vilebrequin dans les moteurs à combustion.

Par exemple un dispositif de détection de la position angulaire d'un arbre à came ou d'un vilebrequin comporte une roue, dite « cible », reliée à l'arbre et munie de dents et de creux, et un capteur de position disposé en regard de la roue.

Le capteur de position comporte un aimant permanent et un ou plusieurs magnétomètres. Les dents et creux de la roue concentrent ou non les lignes de champs de l'aimant permanent, ce qui a pour effet de faire varier le champ magnétique au niveau du ou des magnétomètres.

Le dispositif de détection est soumis aux contraintes suivantes :

- le dispositif doit être capable de détecter de faibles variations de champ magnétique, alors que le champ magnétique permanent ou commun induit par l'aimant permanent est très élevé,
- il subit des vibrations mais celles-ci ne doivent pas ou peu affecter les mesures,
- il est soumis à de forts champs magnétiques externes parasites (ou bruits magnétiques) qui ne doivent pas ou peu perturber la mesure.

Afin de réaliser un capteur de gradient de champ magnétique, deux magnétomètres disposés à une distance donnée l'un de l'autre sont associés. En soustrayant les deux signaux on obtient la valeur du gradient de champ magnétique selon une direction.

Cette technique permet de détecter le passage d'un creux à une dent, ou inversement : un des deux magnétomètres recevant alors un signal plus fort que l'autre. Elle permet également de s'affranchir du champ statique, puisqu'il disparaît lors de la soustraction des deux signaux. L'effet des champs parasites qui sont à peu près égaux au niveau des deux magnétomètres s'annulent également lors de la soustraction. Cette lecture de la dérivée spatiale, ou gradient, du champ magnétique permet donc de détecter de faibles variations de champ et de s'affranchir des champs magnétiques externes.

Afin de rendre le dispositif robuste par rapport aux vibrations, on utilise des capteurs sans pièce mobile, tels que les capteurs magnéto-résistifs comportant une ou des couches magnétiques dont la résistance varie en fonction du champ magnétique ambiant, ou des capteurs à effet Hall.

Cependant, même si lors de la soustraction le champ magnétique commun est annulé, celui-ci est nécessairement mesuré par les deux magnétomètres. Chaque magnétomètre doit être capable de mesurer le fort champ magnétique statique tout en gardant assez de précision pour mesurer les faibles variations que l'on souhaite mesurer.

Par ailleurs en ce qui concerne l'annulation du champ commun et du bruit magnétique par soustractions des signaux des deux magnétomètres, celle-ci n'est obtenue que si les magnétomètres et leur chaine de lecture sont complètement identiques. Ceci signifie qu'une différence de gain ou de phase du signal, d'orientation des magnétomètres ou toute autre dissymétrie entre les deux magnétomètres ne permet pas une annulation complète des bruits magnétiques et du champ commun.

Le document US2007 0096729 décrit un dispositif capable à la fois de mesurer un champ magnétique et un gradient de champ magnétique. Il comporte une structure suspendue mobile uniquement en translation. Elle comporte deux jambes à distance l'une de l'autre parcourues par des courants circulant en sens opposé. Lorsqu'un gradient magnétique existe, les deux jambes sont soumises à des forces de Lorentz qui s'exercent en sens opposée. La translation de la structure résulte de la résultante de forces de Lorentz. Il est alors possible de remonter au gradient de champ magnétique.

Cette structure étant mobile en translation, elle est très sensible aux vibrations.

Le document WO2015/058229 et le document US 2012/176129 décrivent un capteur de gradient de champ magnétique ne présentant pas une sensibilité réduite aux vibrations mécaniques dues au milieu environnant.

## EXPOSÉ DE L'INVENTION

C'est par conséquent un but de la présente invention d'offrir un capteur de gradient de champ magnétique capable de mesurer une différence de champ magnétique selon une direction entre deux points de l'espace, peu ou pas sensible aux vibrations et offrant une sensibilité suffisante pour mesurer de faibles différences de champ magnétique.

Le but énoncé ci-dessus est atteint par un capteur de gradient de champ magnétique comportant une structure mécanique actionnable selon au moins un mode mécanique équilibré, des moyens de transduction des champs magnétiques détectés en deux points de la structure en une résultante mécanique de la différence entre ces champs magnétiques et des moyens de transduction de la résultante mécanique en une résultante électrique.

Grâce à l'invention, en mettant en œuvre une structure mécanique pouvant être actionnée selon au moins un mode équilibré, on peut séparer les différents signaux d'entrée, i.e. le gradient de champ, le champ magnétique moyen, les vibrations, en amont des moyens de transduction mécanique-électrique.

En effet, les composantes de gradient de champ magnétique génèrent des mouvements du mode équilibré, alors que le champ magnétique moyen ou commun peut éventuellement mettre en mouvement le ou les modes non-équilibré(s). Quant aux forces inertielles issues des vibrations du milieu environnant, elles ne génèrent principalement que des mouvements du mode non-équilibré.

Ainsi en réalisant un dispositif qui comporte au moins un mode équilibré qui, en outre, présente un gain de transduction électromécanique et/ou un gain de transduction magnétique-mécanique plus élevés pour les mouvements dans le mode équilibré, le dispositif délivre un signal proportionnel au gradient de champ magnétique qui est peu perturbé par les signaux parasites, tels que les vibrations et le champ magnétique moyen.

Par exemple, une structure présentant des gains de transduction électromécaniques équivalents pour les modes équilibré et non-équilibré est telle qu'elle présente une sensibilité mécanique-magnétique dans le mode équilibré plus élevée que dans le mode non-équilibré.

Dans un autre exemple, la structure présente un gain de transduction électromécanique des mouvements dans le mode équilibré très supérieur à celui des mouvements dans le mode non-équilibré, ceci est par exemple obtenu par une structure comportant deux masses aptes à se déplacer dans la même direction et dans des sens opposés, et comportant des moyens de transduction électromécanique mesurant le déplacement de chacune des masses.

La dynamique d'entrée de l'électronique de lecture du dispositif selon l'invention est alors grandement réduite, car l'effet du champ magnétique moyen est annulé ou pour le moins sensiblement diminué. Il est alors possible d'utiliser une électronique relâchée et/ou d'augmenter les performances du capteur. Il en est de même pour la gamme de variation de déplacement mécanique ou d'effort mécanique dans la structure, ce qui permet de diminuer les contraintes sur la résistance du dispositif de détection mécanique, tout en conservant un bon niveau de résolution de mesure.

En outre, puisque la différence des signaux d'intérêt est réalisée mécaniquement, donc très tôt dans la chaîne de mesure, il est possible de mutualiser un grand nombre de composants de la chaîne du conditionnement. En outre les parties de la chaîne de mesure qui ne sont pas communes comportent peu de composants, il est alors plus aisé de réaliser deux parties offrant des propriétés proches en termes de gain de transduction,...

Les moyens de transduction magnétique-mécanique peuvent comporter un ou des matériaux magnétiques permanents, ou des conducteurs électriques traversés par des courants électriques pour générer des forces de Laplace. La mise en œuvre de conducteurs électriques permet avantageusement de pouvoir mesurer soit le gradient de champ magnétique, soit le champ magnétique permanent en inversant le sens de circulation du courant dans un des deux conducteurs. Les moyens de transduction électromécanique peuvent être de type capacitif, piézorésistif, piézoélectrique ou résonant.

La présente invention a alors pour objet un capteur de gradient de champ magnétique comportant un support et une structure comportant au moins un premier et un deuxième élément mobile, au moins un senseur magnétique solidaire mécaniquement d'un des premier et deuxième éléments mobiles, de sorte à pouvoir appliquer un effort mécanique à la structure en présence d'un gradient de champ magnétique, des moyens de couplage entre le premier élément mobile et le deuxième élément mobile, de manière à ce que la structure puisse être déplacée selon au moins un mode mécanique équilibré en présence d'un gradient de champ magnétique, et des moyens de mesure du déplacement de la structure au moins pour le mode équilibré.

Par exemple, le capteur de gradient de champ magnétique comporte au moins deux senseurs magnétiques, chacun des senseurs magnétiques étant solidaire mécaniquement d'un des premier et deuxième éléments mobiles, de sorte à pouvoir appliquer un effort mécanique à la structure en présence d'un gradient de champ magnétique, des moyens de couplage entre le premier élément mobile et le deuxième élément mobile, de manière à ce que la structure puisse être déplacée selon au moins un mode mécanique équilibré en présence d'un gradient de champ magnétique, et des moyens de mesure du déplacement de la structure au moins pour le mode équilibré.

Selon un exemple de réalisation, les moyens de couplage mécanique peuvent être tels qu'ils autorisent un déplacement en translation du premier élément mobile et du deuxième élément mobile l'un par rapport à l'autre le long d'une première direction donnée au moins en sens opposé, correspondant au mode mécanique équilibré.

De manière préférée, le premier élément mobile et le deuxième élément mobile se déplacent en translation dans le même plan. De manière encore plus préférée, les centres d'inertie des premier et deuxième éléments mobiles ont des mouvements ou trajectoires qui s'effectuent selon une même droite, en sens opposé. Le mode mécanique possède ainsi un moment cinétique nul et est peu sensible à une vibration extérieure en rotation.

Les moyens de couplage mécanique peuvent également être solidaires de deux autres éléments mobiles en translation selon une direction orthogonale à la première direction et empêchant le déplacement en phase des premier et deuxième éléments mobiles, correspondant à un mode mécanique non-équilibré. Les moyens de couplage mécanique peuvent être un ressort, par exemple en forme de losange, les premier et deuxième éléments mobiles étant reliés chacun à un sommet du losange, les sommets étant opposés.

Selon un autre exemple, les moyens de couplage mécanique forment une articulation pivot de la structure sur le support. Les moyens de couplage mécanique peuvent relier rigidement le premier élément mobile et le deuxième élément mobile.

Les moyens de mesure du déplacement de la structure en mode équilibré peuvent être des moyens capacitifs. Les moyens de mesure du déplacement de la structure en mode équilibré peuvent comporter au moins deux peignes capacitifs, un peigne (étant solidaire d'un élément mobile et un peigne est solidaire du support et les peignes paires peuvent être connectés électriquement en parallèle. En variante, les moyens de mesure du déplacement de la structure en mode équilibré peuvent comporter au moins une jauge de contrainte suspendue entre le support et les moyens de couplage.

Selon un autre exemple, le capteur de gradient de champ magnétique comporte deux ensembles, chaque ensemble comportant le premier ou le deuxième élément mobile, les moyens de couplage mécanique reliant les deux ensembles. Chaque ensemble peut avoir un mode équilibré.

Chaque ensemble peut être articulé en rotation sur le support autour d'un axe de rotation, les deux axe de rotation des deux ensembles étant parallèles, les moyens de couplage étant tels qu'ils autorisent les mouvement de rotation des deux ensembles en sens opposés et empêchent les mouvements de rotation des deux ensembles dans le même sens.

Dans un exemple de réalisation, chaque senseur magnétique comporte au moins un matériau magnétique permanent déposé sur au moins un élément mobile.

Les deux senseurs magnétiques peuvent avoir des moments magnétiques d'orientation opposée. Les deux senseurs magnétiques peuvent avoir des moments magnétiques de même orientation.

Selon une caractéristique additionnelle, chaque senseur magnétique comporte au moins un conducteur électrique destiné à être traversé par un courant électrique. Le capteur de gradient de champ magnétique peut comporter des éléments conducteurs électriques souples reliant les éléments mobiles à des plots de contact ancrés sur le support. Le au moins un conducteur électrique peut s'étendre dans une direction telle que les forces de Laplace générées mettent en mouvement la structure du dispositif.

En variante, le au moins un conducteur électrique est orienté en direction de l'axe de rotation de la liaison pivot formée par les moyens de couplage mécanique.

## BRÈVE DESCRIPTION DES DESSINS

La présente invention sera mieux comprise sur la base de la description qui va suivre et des dessins en annexe sur lesquels:

- la figure 1 est une représentation schématique d'une chaîne de traitement du signal du capteur selon l'invention,
- la figure 2 est une vue de dessus représentée schématiquement d'un exemple de réalisation d'un capteur de gradient magnétique selon un premier mode de réalisation,
- la figure 3 est une représentation schématique de la force mécanique générée par un gradient de champ en présence d'un matériau magnétique de moment magnétique M,
- la figure 4 est une vue de dessus représentée schématiquement d'une variante du capteur de la figure 2 mettant en œuvre des jauges piézorésistives,
- la figure 5 est une vue de dessus représentée schématiquement d'un autre exemple d'un capteur selon le premier mode de réalisation,
- la figure 6 est une vue de dessus représentée schématiquement d'un autre exemple d'un capteur selon le premier mode de réalisation,
- la figure 7 une vue de dessus représentée schématiquement d'un exemple d'un capteur selon un deuxième mode de réalisation, la structure du capteur étant mobile en rotation dans le plan,
- les figures 8A et 8B sont des représentations schématiques du capteur de la figure 7 illustrant son fonctionnement dans le cas de senseurs magnétiques formés par un matériau magnétique permanent,
- les figures 9A et 9B sont des représentations schématiques du capteur de la figure 7 illustrant son fonctionnement dans le cas de senseurs magnétiques formés par des conducteurs électriques,
- la figure 10 est une vue de dessus représentée schématiquement d'un exemple d'un capteur selon un deuxième mode de réalisation, particulièrement adapté à la mise en œuvre de senseurs magnétiques formés par des conducteurs électriques,
- la figure 11 est une vue de dessus représentée schématiquement d'un exemple d'un capteur selon un autre mode de réalisation,
- la figure 12A une vue de dessus représentée schématiquement d'un exemple d'un capteur selon le deuxième mode de réalisation, la structure du capteur étant mobile en rotation hors-plan,
- la figure 12B est une vue en coupe du capteur de la figure 12A le long d'un plan de coupe A-A',
- la figure 13 une vue de dessus représentée schématiquement d'un autre exemple d'un capteur selon le deuxième mode de réalisation, mettant en œuvre deux ensembles mobiles en rotation dans le plan,
- la figure 14 une vue de dessus représentée schématiquement d'un autre exemple d'un capteur selon le deuxième mode de réalisation, mettant en œuvre deux ensembles mobiles en rotation hors-plan,
- la figure 15 est une représentation schématiquement d'un élément mobile d'un capteur selon l'invention comportant un senseur magnétique formé par des conducteurs électriques.

## EXPOSÉ DÉTAILLÉ DE MODES DE RÉALISATION PARTICULIERS

Dans la description qui va suivre le dispositif de mesure ou capteur de gradient de champ magnétique sera désigné dispositif de mesure de gradient de champ ou capteur de gradient de champ.

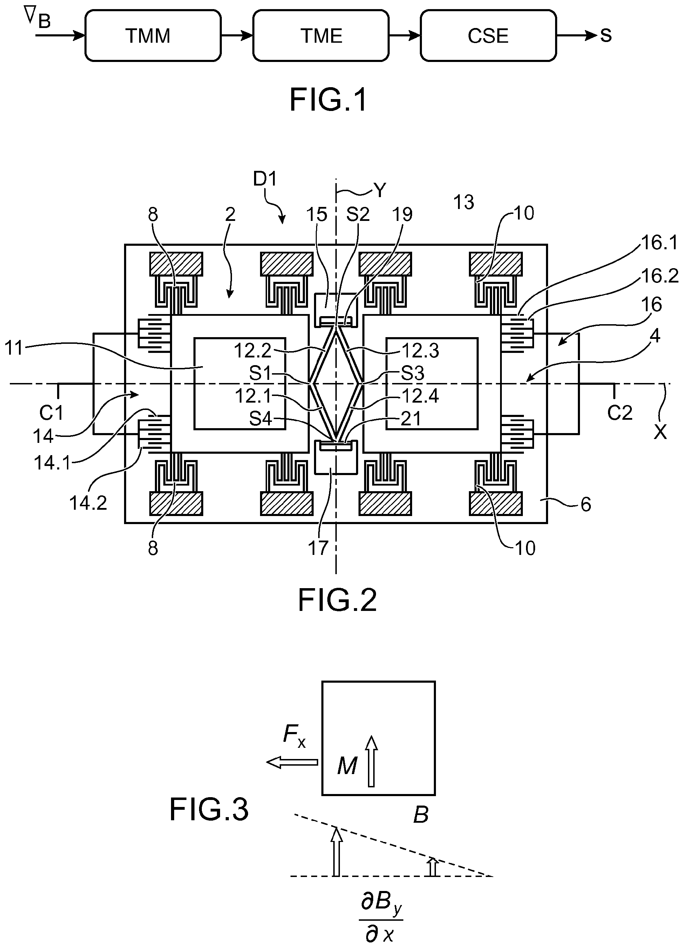

Sur la figure 1, on peut voir une représentation schématique de la chaîne de mesure du dispositif de mesure de gradient de champ selon l'invention.

La chaîne de mesure comporte des moyens de transduction magnétique-mécanique désignés TMM transformant le gradient de champ magnétique VB en un effort mécanique proportionnel au gradient de champ qui génère un déplacement x, des moyens de transduction mécanique-électrique désignés TME convertissant le déplacement proportionnel au gradient de champ magnétique en un signal électrique représentatif du gradient de champ magnétique, et des moyens de conditionnement du signal électrique désigné CSE produisant le signal de mesure s délivré par le capteur.

Dans le cas où les moyens CSE mettent en œuvre des jauges piézorésistives, elles peuvent être montées en pont de Wheatstone. Le pont est polarisé en tension ou en courant, et le signal de mesure s est une lecture de la tension en sortie du pont.

Dans le cas où les moyens CSE mettent en œuvre des moyens capacitifs, les condensateurs à capacité variable sont polarisés. L'électronique de lecture absorbe et dénombre les charges déplacées lors des variations de capacités.

Dans le cas où les moyens CSE sont des moyens résonants mettant en œuvre au moins une jauge, la jauge est excitée et est maintenue en vibration à sa fréquence de résonance par un asservissement, par exemple une boucle à verrouillage de phase ou PLL (Phase-Locked Loop en terminologie anglo-saxonne). La fréquence de résonance varie en fonction de la contrainte dans la jauge et est mesurée.

Les moyens de transduction magnétique-mécanique TMM présentent un gain ou sensibilité de transduction aux mouvements du mode équilibré désigné $G_e$ et aux mouvements du mode non-équilibré désigné $G_{ne}$. Les moyens de transduction mécanique-électrique ou moyens de transduction électromécanique TME présentent un gain ou sensibilité de transduction aux mouvements du mode équilibré désigné $T_e$ et aux mouvements du mode non-équilibré désigné $T_{ne}$.

Concernant le gain des moyens de transduction magnétique-mécanique, les efforts exercés sur le mode équilibré de la structure mécanique sont seulement proportionnels au gradient de champ magnétique. On peut alors écrire

$$F_{\partial B} \propto \partial_i B_j$$

Comme cela sera décrit par la suite, les moyens de transduction peuvent mettre en œuvre des conducteurs électriques, dans lesquels circule un courant pour générer des forces de Laplace provoquant un déplacement d'une ou plusieurs parties du dispositif, ou un matériau magnétique.

Il en résulte un mouvement mécanique du mode équilibré désigné $x_e$ caractérisé par une sensibilité de transduction mécanique :

$$x_e = G_e F_{\partial B}$$

Les modes non-équilibrés sont, quant à eux, sensibles aux vibrations et éventuellement au champ magnétique moyen. L'amplitude de vibration des modes non-équilibrés désigné $x_{ne}$ s'exprime :

$$x_{ne} = G_{ne}(F_{vib} + F_B)$$

Des moyens de transduction électromécaniques tels que des peignes capacitifs, des jauges piézorésistives, dont les sensibilités à ces deux mouvements sont caractérisées par $T_e$ et $T_{ne}$, transforment ensuite ces mouvements en un seul signal s :

$$s = T_e x_e + T_{ne} x_{ne}$$

Soit $s = T_e G_e F_{\partial B} + T_{ne} G_{ne} (F_{vib} + F_B)$

L'invention propose un dispositif émettant un signal de sortie tel qu'il soit peu perturbé par les signaux parasites tels que les vibrations et le champ magnétique permanent, en agissant sur les gains de transductions $G_e$, $G_{ne}$, $T_e$, $T_{ne}$.

Sur la figure 2, on peut voir un exemple de réalisation d'un dispositif de mesure de gradient de champ selon un premier mode de réalisation.

Selon le premier mode de réalisation, les mouvements utiles des éléments mobiles sont des mouvements de translations dans une direction donnée.

Le dispositif D1 comporte un premier élément mobile ou masse 2 et un deuxième élément mobile ou masse 4 principalement en translation le long de la direction X.

Chaque élément mobile 2, 4 est suspendu par rapport à un support 6 dans le plan du dispositif.

De manière avantageuse, le premier élément mobile 4 est suspendu par quatre moyens de suspension 8 disposés au niveau des sommets des éléments mobiles permettant de bloquer les degrés de liberté en rotation. Les moyens de suspension sont par exemple formés par des poutres souples permettant un déplacement du premier élément mobile 2 selon la direction X et limitant les déplacements du premier élément mobile 2 dans la direction Y et dans la direction Z.

Le deuxième élément mobile 4 est également suspendu avantageusement par quatre moyens de suspension 10 au niveau des sommets du deuxième élément mobile 4. Le moyens de suspension sont formés par des poutres souples permettant un déplacement du deuxième élément mobile 4 selon la direction X et limitant les déplacements du premier élément mobile 2 dans la direction Y et dans la direction Z.

Le dispositif comporte également des moyens de couplage mécanique 12 des deux éléments mobiles 2, 4 de sorte à actionner le dispositif selon au moins un mode équilibré. Les moyens de couplage 12 forment un ressort transmettant un effort d'une extrémité à l'autre du ressort. La forme des moyens de couplage peut être quelconque.

Dans l'exemple représenté, les moyens de couplage 12 comportent quatre poutres 12.1, 12.2, 12.3, 12.4 formant un losange. Une extrémité longitudinale des poutres 12.1 et 12.2 est connectée au premier élément mobile en un sommet S1 et une extrémité longitudinale des poutres 12.3 et 12.4 est connectée au deuxième élément mobile en un sommet S2. L'autre extrémité des poutres 12.1 et 12.3 est connectée à un plot d'ancrage 15 en un sommet S3 et l'autre extrémité des poutres 12.2 et 12.4 est connectée à un plot d'ancrage 17 opposé au plot 15 par rapport à l'axe X, en un sommet S4. La raideur est en particulier contrôlée par la largeur des poutres, le module d'Young du matériau utilisé, mais également l'angle des poutres les unes par rapport aux autres.

Dans l'exemple représenté, la connexion entre les poutres 12.1 et 12.3 au plot 15 se fait par l'intermédiaire d'une poutre 19 ancrée sur le plot 15 et la connexion entre les poutres 12.2 et 12.4 au plot 17 se fait par l'intermédiaire d'une poutre 21 ancrée sur le plot 17. Les poutres 19, 21 sont déformables en flexion et permettent aux sommets S2 et S4 de se déplacer selon la direction Y, mais ils ne se déplacent pas selon la direction X, pour assurer que le centre du losange ne bouge pas.

Le losange se déforme principalement dans la direction X, les sommets S1 et S2 se déplaçant l'un par rapport à l'autre le long de la direction X.

Selon un autre exemple, les moyens de couplage comportent une structure de ressort composée de poutres en forme de U dont les bras principaux sont perpendiculaires à la direction X.

Les moyens de couplage 12 permettent à la structure d'être actionné selon au moins un mode mécanique équilibré et un mode mécanique non-équilibré.

Un mode mécanique d'une structure est dit équilibré lorsque le centre d'inertie de la structure est immobile lors de la mise en mouvement de la structure selon ce mode. A l'inverse un mode mécanique d'une structure est dit non-équilibré lorsque le centre d'inertie de la structure se déplace avec la structure qui est mise en mouvement selon ce mode.

Dans l'exemple représenté, le mode équilibré correspond à un déplacement en opposition de phase des éléments mobiles, i.e. les sommets S1 et S2 se déplacent symétriquement l'un par rapport à l'autre par rapport à l'axe Y. Les sommets S1 et S2 s'éloignent ou se rapprochent l'un de l'autre. Le mode non-équilibré correspond à un déplacement en phase des éléments mobiles, les sommets S1 et S2 se déplaçant simultanément dans le même sens dans la direction X.

Dans l'exemple représenté et de manière avantageuse, le moyens TMM comportent deux éléments de matériau magnétique permanent 11, 13, chaque élément de matériau magnétique 11, 13 étant solidaire en mouvement de chaque élément mobile 2, 4 et apte à mettre en mouvement chacun des éléments mobiles 2, 4 sous l'effet d'un champ magnétique. Les éléments 11 et 13 sont désignés « senseurs magnétiques ». Un matériau magnétique présente un moment magnétique M, qui est orienté, de sorte à générer une force mécanique sur l'élément mobile dans la direction de déplacement de celui-ci, selon l'axe X dans l'exemple représenté, en présence d'un gradient de champ magnétique.

La surface des éléments mobile est suffisante pour permettre le dépôt du matériau magnétique, de préférence elle présente une largeur de l'ordre de plusieurs dizaines de μù , par exemple au moins 50 μm, voire 100 μm.

En outre les éléments mobiles présentent une épaisseur dans la direction Z suffisante pour les éléments soient peur déformables permettant de conserver l'intégrité de la ou des couches de matériau magnétique. L'épaisseur des éléments est de préférence comprise entre quelques centaines de nm à quelques micromètres.

Dans cet exemple et plus généralement pour les structures dont la masse est en mouvement de translation imposé, un seul senseur sur un des éléments mobiles peut être utilisé, il produit une force qui est directement proportionnelle au gradient de champ.

Chaque matériau magnétique génère une force magnétique qui peut s'écrire $F = M.\nabla B = \nabla(M. B)$ pour des moments magnétiques constants.

La force mécanique F appliquée à un élément mobile est donc directement proportionnelle au gradient de champ.

Sur la figure 3, on peut voir représenté un moment magnétique orienté selon la direction Y et le gradient de champ selon Y le long de la direction X.

La force selon l'axe X s'écrit :

$$F_x = M_y \frac{\partial B_y}{\partial x}$$

Pour un moment M constant orienté selon l'axe X et un gradient selon X le long de l'axe X, la force selon l'axe X s'écrit :

$$F_x = M_x \frac{\partial B_x}{\partial x}$$

Il est ainsi possible d'accéder aux différentes composantes de gradient de champ magnétique, en choisissant les orientations du moment *M* par rapport à l'axe sur lequel on souhaite produire une force.

Les senseurs magnétiques permanents sont par exemple réalisés sous forme de couches déposées sur au moins une face d'au moins un élément mobile.

Le senseur magnétique 11 a un moment magnétique M1 et le senseur magnétique 13 a un moment magnétique M2.

De préférence, les matériaux 11 et 13 ont des moments magnétiques de modules égaux. Avantageusement ils sont réalisés dans le même matériau et ont le même volume.

De manière avantageuse, les matériaux des senseurs magnétiques sont déposés sur les premier et deuxième éléments mobiles de sorte que leurs moments magnétiques soient d'orientations opposées.

En effet, on peut réaliser sur une même structure des couches de matériaux magnétiques ayant des moments magnétiques d'orientations différentes, par exemple opposées grâce au phénomène d'anisotropie de forme, tel que décrit dans le document US 2011/0151589. En variante, il est également envisageable d'orienter le moment magnétique de matériaux magnétiques différemment pour des zones voisines en chauffant localement avec un laser sous un champ magnétique orienté selon la direction désirée.

Les moyens de transduction mécanique-électrique TME comportent des moyens 14, 16 de détection du déplacement selon X de chaque première et deuxième partie.

Dans l'exemple représenté, les moyens de détection 14, 16 sont de type capacitif à variation de surface, comportant chacun un ou des peignes solidaires 14.1, 16.1 en mouvement des éléments mobiles et des peignes 14.2, 16.2 solidaires du support 6, les peignes 14.1, 14.2 et 16.1, 16.2 étant interdigités. Dans l'exemple représenté, les moyens de détection 14 comportent deux paires de peignes interdigités et les moyens de détection 16 comportent deux paires de peignes interdigités. Selon un autre exemple, les moyens de détection 14, 16 pourraient comporter chacun une seule paire de peignes interdigités s'étendant sur toute le côté des éléments mobiles 2, 4 le long de la direction Y.

Les moyens 14 ont une capacité C1 et les moyens 16 ont une capacité C2.

Les moyens de détection 14, 16 peuvent être connectés électriquement de sorte à permettre directement une lecture différentielle.

En variante, les moyens de détection peuvent comporter un peigne solidaire du premier élément mobile 2 et un peigne solidaire du deuxième élément mobile 4, les deux peignes étant interdigités.

Le fonctionnement du dispositif D1 va maintenant être décrit.

Un gradient de champ magnétique ΔB s'appliquent à la structure et aux deux éléments mobiles 2, 4 et aux senseurs magnétiques 11, 13 respectivement.

Chaque senseur 11, 13 magnétique génère une force F1, F2 proportionnelle au gradient de champ.

$$F_1 = M1.\nabla B$$

$$F_2 = M2.\nabla B$$

Le mode équilibré est mis en mouvement par la force $F_e$. Les éléments mobiles ont un déplacement en mode équilibré $x_e$. Le mode non-équilibré est mis en mouvement par la force $F_{ne}$. Les éléments mobiles ont un déplacement en mode non-équilibré $x_{ne}$.

$$F_e = \frac{F_1 - F_2}{2} = \frac{M_1.\nabla B - M_2.\nabla B}{2}$$

$$F_{ne} = \frac{F_1 + F_2}{2} = \frac{M_1.\nabla B + M_2.\nabla B}{2}$$

Par ailleurs, la structure est soumise au champ magnétique moyen et éventuellement aux vibrations extérieures.

La structure est donc actionnée simultanément dans un mode mécanique équilibré et dans un mode mécanique non-équilibré.

Par définition, un mode équilibré n'est pas sensible aux vibrations. Dans cet exemple de réalisation, le mode équilibré n'est pas sensible au champ magnétique moyen. A l'inverse, le mode non-équilibré peut être sensible aux vibrations le long de l'axe X et peut être sensible au champ magnétique moyen mais également à une force de gradient de champ $F_{ne}$.

Il est à noter que le champ magnétique exerce des couples mécaniques opposés de modules sensiblement identiques sur les deux éléments mobiles.

En effet le couple mécanique s'appliquant sur un élément de volume dV portant un matériau de moment magnétique M s'écrit :

$$d\Gamma = M \wedge B dV$$

Mais leur action mécanique sur le mode équilibré lié à la chaîne de mesure est négligeable. La rotation des éléments mobiles est bloquée par les ressorts, ce qui diminue l'amplitude de perturbations produites par le couple mécanique sur le mode équilibré.

Le déplacement des premier et deuxième éléments mobiles sont mesurés par les moyens capacitifs.

Selon l'invention, le signal en sortie s de la chaîne de mesure est généré par le déplacement $x_e$, et la chaîne de mesure offre une sensibilité réduite au déplacement Xne.

Dans un exemple de réalisation, les capacités C1 et C2 sont lues indépendamment l'une de l'autre. Les signaux sont ajoutés, ce qui contribue également à éliminer le résidu du signal de déplacement du mode non équilibré les mesures sont additionnées, ce qui contribue également à éliminer le résidu du signal de déplacement du mode non équilibré.

Dans un autre exemple de réalisation, les moyens de détection capacitive 14, 16 sont connectés en parallèle de sorte à réaliser une lecture différentielle. La capacité C équivalente s'écrit :

$$C = C1 + C2$$

Cette configuration d'électrodes permet d'éliminer la sensibilité au mouvement du mode non-équilibré $x_{ne}$. En effet un mouvement en phase (mode non-équilibré) des deux éléments mobiles produit simultanément des variations opposées des capacités C1 et C2 : la capacité C conserve ainsi sa valeur. En revanche un mouvement en opposition de phase (mode équilibré) produit une variation de capacité qui peut être lue par une électronique de lecture optimisée sur la gamme de variation souhaitée pour le capteur de gradient de champ magnétique.

Les moyens de transduction TME du dispositif de la figure 2 présentent un gain de transduction $T_e$ en mode

équilibré très supérieur à celui en mode non-équilibré $T_{ne}$, ils sont donc principalement sensibles aux mouvements du mode équilibré. Cette différence de gain est obtenue grâce aux moyens de couplage des deux masses, qui est en forme de losange dans l'exemple représenté, qui opposent une forte raideur à tout déplacement en phase et autorisent les mouvements symétriques. Enfin, la lecture des variations de capacité n'est pas sensible aux mouvements dans le mode non-équilibré dus par exemple aux vibrations mécaniques, et ne conservent que les variations dues aux mouvements dans le mode équilibré dus au gradient de champ magnétique. De préférence, on cherche à atteindre à rapport Te/ne < 5.

Dans un exemple avantageux du dispositif de la figure 2, les deux senseurs magnétiques ont des moments magnétiques d'orientations opposées : $M_1 = - M_2 = M$.

Le premier senseur magnétique 11 applique alors sur l'élément mobile 2 une force mécanique $F_1 = M. \nabla B$.

Les moments magnétiques de deux senseurs magnétiques ayant des orientations opposées, le deuxième senseur magnétique 13 applique alors sur l'élément mobile 4 une force mécanique $F_2 = —M. \nabla B$.

Il en résulte que les forces $F_e$ et $F_{ne}$ respectivement produites sur les modes équilibré et non-équilibré ont alors pour expression :

$$F_e = \frac{F_1 - F_2}{2} = M. \nabla B$$

$$F_{ne} = \frac{F_1 + F_2}{2} = 0$$

La force $F_e$ est directement proportionnelle au gradient de champ VB.

Dans ces conditions, la valeur de $F_e$ est avantageusement maximisée, le signal utile pour générer le signal électrique est également maximisé.

Puisque $F_{ne}$ est nulle, le mode non-équilibré est essentiellement actionné par les vibrations.

De préférence, les deux moments sont de signes opposés.

Dans un autre exemple, le dispositif de la figure 2 comporte deux éléments mobiles 2, 4 et un seul senseur magnétique générant un seul moment magnétique, sur l'un des éléments mobiles 2, 4.

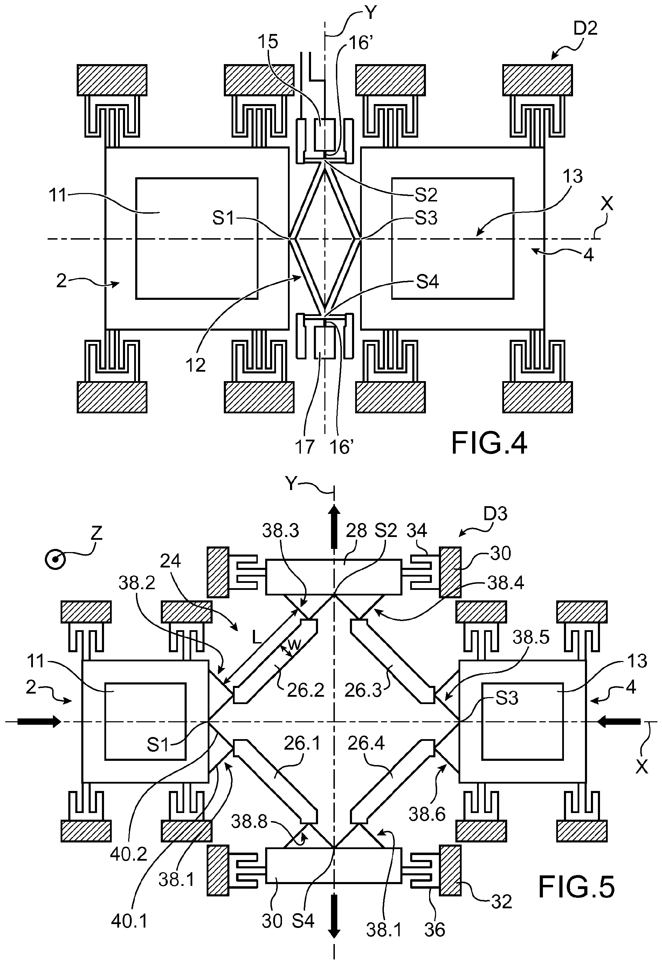

Sur la figure 4, on peut voir une variante D2 du dispositif de la figure 2 dans lequel les moyens TME comportent des jauges de contraintes 16'. Ces jauges peuvent être piézoélectrique, piézorésistives ou résonantes.

Dans l'exemple représenté, une jauge 16' est suspendue entre le sommet S3 du losange et le plot d'ancrage 15 et une jauge 16' est suspendue entre le sommet S4 et le plot d'ancrage 17.

Du fait de la symétrie de la structure par rapport à l'axe aligné avec les deux jauges, les jauges 16' subissent une déformation nulle au premier ordre lorsque les deux éléments mobiles oscillent en phase.

Lorsque les deux éléments mobiles oscillent en opposition de phase, les jauges 16' sont mises en compression ou en extension. Une électronique de lecture permet ensuite de mesurer les variations de résistance électrique dans les jauges proportionnelles au mouvement du mode équilibré $x_e$. Cette configuration permet de préserver les jauges des déformations produites par le mode non-équilibré.

Les moyens de transduction TME du dispositif de la figure 4 présentent un gain de transduction $T_e$ en mode équilibré très supérieur à celui en mode non-équilibré $T_{ne}$, ils sont donc principalement sensibles aux mouvements du mode équilibré.

Les moyens de couplage 12 rejettent le mode non équilibré et transforment le mode équilibré en déplacement selon l'axe Y qui est l'axe des jauges, alors que l'effet du mode non-équilibré reste selon l'axe X.

Dans un autre exemple de réalisation, on peut prévoir de monter les jauges en différentiel, par exemple l'une des jauges est disposée comme sur la figure 4 à l'extérieur du losange, et l'autre jauge est montée à l'intérieur du losange.

En outre, puisque seul le déplacement dû au gradient de champ est mesuré, la gamme de mesure du dispositif peut être optimisée pour la grandeur à mesurer, i.e. le gradient de champ magnétique, et n'est pas imposée par les signaux parasites (vibrations, champ magnétique permanent) qui transitent sur le mode non-équilibré.

En variante, les moyens de transduction magnétique-mécanique TMM pourraient être du type à force de Laplace, également appelé à force de Lorentz.

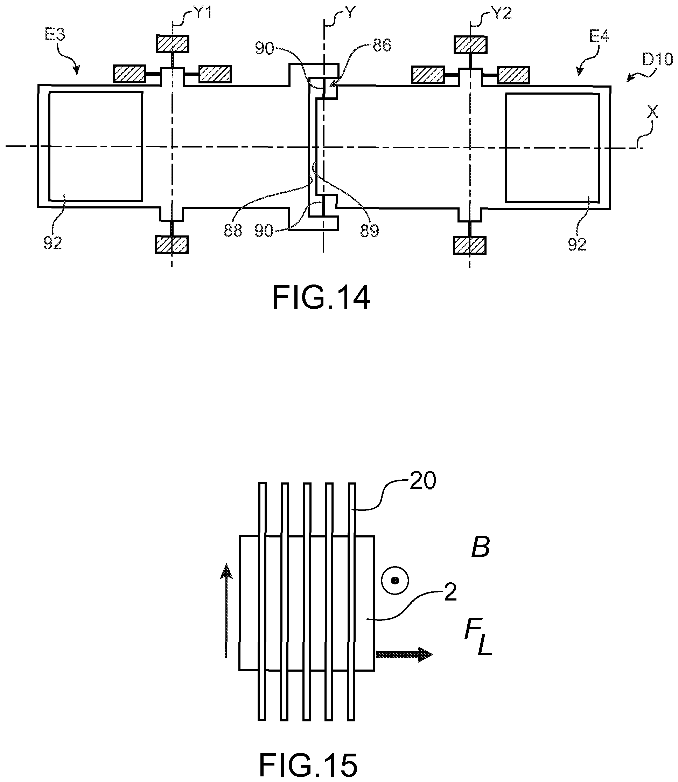

Par exemple, des conducteurs électriques 20, tels que des lignes de courant électriques, sont solidarisés aux deux éléments mobiles. Sur la figure 15, on peut voir représenté schématiquement un élément mobile 2 et des conducteurs électriques 20.

Les conducteurs sont disposés parallèlement les uns par rapport aux autres, de sorte que les forces de Laplace s'appliquant sur chaque conducteur aient la même direction et agissent dans le même sens sur l'élément mobile. De préférence plusieurs conducteurs sont mis en œuvre pour générer une force mécanique plus importante sur l'élément mobile, mais il pourrait être envisageable de ne mettre en œuvre qu'un seul conducteur. Dans l'exemple de la figure 2, les conducteurs électriques sont perpendiculaires à l'axe X le long duquel les éléments 2 et 4 sont destinés à se déplacer.

La structure est sensible aux gradients de champ $B_Z \left( \frac{\partial B_Z}{\partial x} \right)$.

Les conducteurs électriques sont solidaires des éléments mobiles sur lesquels ils reportent leurs efforts mécaniques. Par exemple, une couche de matériau isolant électrique peut être intercalée entre les conducteurs électriques et le corps de l'élément mobile afin d'assurer leur isolation électrique. En variante, les conducteurs électriques pourraient être formés dans le corps de l'élément mobile par gravure. L'alimentation en courant électrique des conducteurs peut être réalisée par l'intermédiaire de lignes conductrices suspendues de faibles raideurs qui réalisent un pont entre le substrat et les éléments mobiles. Alternativement, l'alimentation électrique pourrait être réalisée par l'intermédiaire des éléments mécaniques déformables qui assurent également la suspension des éléments mobiles.

La force de Laplace $F_L$ correspond à un effort mécanique exercé par le champ magnétique sur un conducteur électrique traversé par une densité de courant j.

Une force élémentaire $dF = j \wedge BdV$ est produite sur un élément de conducteur $dV$ de la structure. Pour une ligne de conducteur parcourue par un courant $I$, on peut retenir :
$dF = I \wedge Bdl$ pour une longueur de conducteur $dl$.

On peut calculer la force de Laplace $F_L$ (figure 15) qui résulte de l'intégration de la force de Laplace sur l'ensemble de la pièce mobile et exercée par tous les conducteurs :
$F_L = \beta I_L B$ $F_L$, le facteur $\beta$ traduisant l'intégration sur tous les conducteurs.

Il résulte de la relation entre la force de Laplace au champ B, qu'afin de générer un signal proportionnel à un gradient de champ, des conducteurs électriques sont à réaliser sur les deux éléments mobiles. La structure mécanique est soumise à des efforts mécaniques qui diffèrent les uns des autres entre autres du gradient de champ magnétique.

Par calcul, la force généralisée qui s'applique sur le mode mécanique équilibré s'écrit comme une combinaison des efforts $F_1$ et $F_2$ :

$$F_e = \alpha_1 F_1 + \alpha_2 F_2$$

$\alpha_i$ est un paramètre qui résulte de la projection des efforts sur le mode équilibré.
avec

$$F_1 = \beta_1 I_{L1} B(x_0) - \beta_1 I_{L1} \frac{\partial B}{\partial x}(x_0)\frac{a}{2}$$

$$F_2 = \beta_2 I_{L2} B(x_0) + \beta_2 I_{L2} \frac{\partial B}{\partial x}(x_0)\frac{a}{2}$$

ou $\beta_1$ et $\beta_2$ sont des paramètres géométriques de la structure équivalents à une longueur de conducteur électrique, $\beta_1$ et $\beta_2$ peuvent être différents l'un de l'autre. En ajustant les courants $I_{L1}$ et $I_{L2}$ de manière à éliminer la composante de champ moyen $B_{x0}$ dans la force $F_e$, on obtient une force sur le mode équilibré qui ne dépend que du gradient de champ magnétique. $F_e$ ne dépend que du gradient de champ magnétique. Lorsque :

$$\alpha_1 \beta_1 I_{L1} + \alpha_2 \beta_2 I_{L2} = 0.$$

Ceci peut être obtenu lorsque :

| | | | | |
|---|---|---|---|---|
| **Cas 1** | $\alpha_1 = \alpha_2$ | $\beta_1 = \beta_2$ | $I_{l1} = -I_{l2}$ | $F_e = -\alpha \beta I_L \frac{\partial B}{\partial x}(x_0)a$ |
| **Cas 2** | $\alpha_1 = -\alpha_2$ | $\beta_1 = \beta_2$ | $I_{l1} = I_{l2}$ | $F_e = -\alpha \beta I_L \frac{\partial B}{\partial x}(x_0)a$ |

Lorsque des courants identiques et de même sens de circulation sont injectés dans les conducteurs électriques, des forces généralisées sur le mode équilibré et non-équilibré sont générées :

$$F_e = \frac{F_1 - F_2}{2} = \beta I_L \frac{\partial B_z}{\partial x} a$$

$$F_{ne} = \frac{F_1 + F_2}{2} = \beta I_L B_z$$

avec $a$ la distance entre les centres géométriques des deux éléments mobiles ; $a$ est multiplié par le gradient magnétique pour obtenir la différence de champs entre les deux centres géométriques des éléments mobiles.

Deux modes de fonctionnement peuvent être distingués :

Selon un premier mode de fonctionnement, le courant $I_L$ circulant dans les conducteurs électriques des deux éléments mobiles est maintenu constant. Cela revient alors à mettre en œuvre un matériau magnétique permanent comme cela é été décrit ci-dessus. Les moyens de transduction électromécanique différentiels mis en œuvre dans le dispositif de la figure 2 permettent d'écarter le mouvement du mode non-équilibré $x_{ne}$ du signal de sortie s du capteur. Il est à noter que la mise en œuvre de matériau magnétique permanent comme moyens de transduction TMM présente l'avantage de réduire la consommation électrique du capteur par rapport aux conducteurs électriques utilisés pour générer les forces de Laplace.

Selon un deuxième mode de fonctionnement, le courant $I_L$ est modulé à une fréquence $f_p$ : les forces exercées sur les modes équilibré et non-équilibré sont ainsi reportées dans le domaine fréquentiel sur cette même fréquence.

En choisissant avantageusement la fréquence $f_p$ en dehors de la bande de fréquence des vibrations, on obtient une séparation du signal de gradient de champ magnétique avec ceux des vibrations dans le domaine fréquentiel.

De manière très avantageuse, en choisissant la fréquence $f_p$ proche de la fréquence de résonance du mode équilibré, la sensibilité du capteur au signal de gradient de champ magnétique peut être améliorée d'un facteur proche du facteur de qualité $Q$ de ce même mode. Le mode mécanique non-équilibré produit, quant à lui, un mouvement proportionnel au champ magnétique moyen : cependant le signal d'excitation associé étant en dehors de la bande de résonance du mode non-équilibré, le mouvement $x_{ne}$ produit reste modéré.

La mise en œuvre de senseurs magnétiques avec des conducteurs électriques traversés par des courants électriques présente en outre l'avantage de permettre de mesurer très facilement le champ magnétique permanent ou moyen, simplement en inversant le sens du courant dans le senseur magnétique. La pleine échelle peut être adaptée avec l'intensité des courants électriques injectés dans les senseurs. Le dispositif permet alors de mesurer le gradient de champ magnétique ou le champ magnétique moyen en étant peu sensible aux vibrations.

Les moyens de transduction TME mis en œuvre dans le dispositif de la figure 2 permettent avantageusement de réduire la sensibilité aux signaux parasites présents dans le mouvement du mode non-équilibré.

Sur la figure 5, on peut voir un autre exemple d'un dispositif D3 selon le premier mode de réalisation, dans lequel il est possible de modifier les sensibilités mécaniques des modes équilibré et non-équilibré, de sorte à avoir un gain de transduction Ge très supérieur au gain $G_{ne}$.

Le dispositif D3 diffère du dispositif D2 au niveau des moyens de couplage.

Les moyens de couplage 24 ont également la forme d'un losange. Les poutres 26.1 à 26.4 présentent une forte raideur transverse. Par exemple elles présentent une largeur w importante et une longueur L réduite. En effet la raideur transverse est proportionnelle au rapport $(w/L)^3$. Le rapport w/L est par exemple compris entre 1/20 et 1.

En outre, les sommets S2 et S4 sont connectés à des plots mobiles 28, 30 en translation le long de la direction Y. Les plots 28, 30 sont suspendus à des plots d'ancrage 30, 32 par des éléments élastiques 34, 36 respectivement.

Par ailleurs, chaque extrémité de chaque poutre 26.1 à 26.4 est connectée aux éléments mobiles et aux plots mobiles par des articulations pivots 38.1 à 38.8.

Dans l'exemple représenté toutes les articulations pivots sont similaires, nous ne décrirons en détail que l'articulation 38.1.

L'articulation pivot 38.1 relie la poutre 26.1 à l'élément mobile 2.

L'articulation pivot 38.1 comporte deux poutres 40.1, 40.2. Chaque poutre 40.1, 40.2 a une première extrémité longitudinale fixée à une extrémité longitudinale de la poutre 26.1 en un même point correspondant à l'intersection de l'axe de rotation de l'articulation pivot 38.1 et du plan du dispositif. Chaque poutre 40.1, 40.2 comporte une deuxième extrémité fixée sur l'élément mobile en un point distinct de celui auquel est fixée l'autre poutre. Les poutres 40.1, 40.2 forment alors avec un bord de l'élément mobile un triangle. Dans l'exemple représenté et de manière avantageuse, les poutres 40.1, 40.2 forment un angle de 90° entre elles.

Selon un autre exemple de réalisation, les liaisons pivots comportent chacune une seule poutre présentant une raideur en flexion faible dans le plan, formant une lame. Ceci est rendu possible par le fait que le déplacement des éléments connectés est déjà limité à une translation par leurs ressorts.

Dans un autre exemple, les liaisons pivots comportent deux lames en triangle, présentant plus de rigidité face aux déplacements non voulus, chaque lame réduisant fortement les raideurs associées à l'autre lame qui ne sont pas désirées.

Cet arrangement permet de bloquer les degrés de libertés en translation selon les axes X et Y et d'offrir une raideur en torsion autour de l'axe Z suffisamment faible pour permettre une rotation relative des pièces reliées les unes aux autres. La structure de couplage est alors telle que deux sommets opposés du losange ont des déplacements de même direction et des sens opposés, qui sont donc symétriques par rapport au centre.

Il en résulte que le mouvement du mode non-équilibré (déplacement des sommets opposés S1 et S3 du losange dans la même direction et même sens) est bloqué par les plots mobiles qui ne peuvent se déplacer que selon l'axe Y.

Par conséquent, le gain de transduction $G_{ne}$ du mode non-équilibré est réduit par rapport au mode équilibré $G_e$.

De préférence, le rapport $G_{ne}/G_e < 0,2$, ce qui permet d'apporter un gain appréciable pour rejeter les signaux produits par les vibrations.

Le dispositif comporte également des moyens de transduction TMM et des moyens de transduction TME (non représentés) qui sont similaires à ceux des dispositifs des figures 2 et 4. En mettant en œuvre les moyens de détection capacitif ou à jauge de contrainte des dispositifs D1 et D2 permettant un déséquilibre des gains $T_e$ et $T_{ne}$ Ce dispositif rejette fortement le mode non-équilibré.

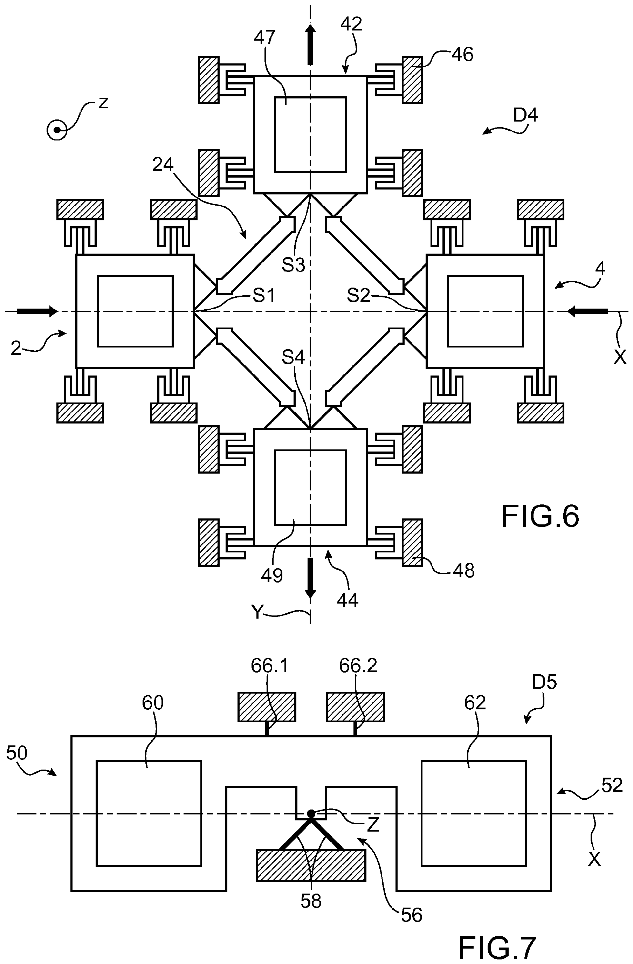

Sur la figure 6, on peut voir un autre exemple d'un dispositif D4 selon le premier mode de réalisation dans lequel les sommets S3 et S4 du losange sont solidaires en mouvement des troisième 42 et quatrième 44 éléments mobiles.

Les troisième et quatrième éléments mobiles sont suspendus à des plots d'ancrage 46, 48 par des moyens de ressort autorisant un déplacement en translation le long de la direction Y et limitant les déplacements selon la direction X et en rotation autour de l'axe Z. Les troisièmes et quatrième éléments mobiles peuvent comporter également des moyens de transductions magnétique-mécanique TMM, par exemple une ou plusieurs couches de matériau magnétique permanent 47, 49 ou des conducteurs électriques alimentés en courant, pour permettre la génération de forces de Laplace agissant sur les éléments mobiles.

En mode équilibré, les premier 2 et deuxième 4 éléments mobiles se déplacent le long de l'axe X en sens opposé et les troisième 42 et quatrième 44 éléments mobiles se déplacent en sens opposé le long de l'axe Y, et lorsque les premier et deuxième éléments mobiles se rapprochent les troisième et quatrième éléments mobiles s'éloignent et inversement

Le mouvement de la structure de la figure 6 est dominé par le mode équilibré.

Suivants les configurations, par exemple suivant le choix des moments magnétiques des différents senseurs magnétiques ou les niveaux de courant traversant les conducteurs électriques, on peut déterminer par exemple la composante du gradient de champ dans la direction Y ou Z le long de l'axe X, ou la composante du gradient de champ dans la direction X ou Z le long de la direction Y.

Dans un autre exemple de réalisation, le dispositif comporte au moins un senseur sur l'une des quatre éléments mobiles.

Sur la figure 7, on peut voir un exemple d'un dispositif selon un deuxième mode de réalisation dans lequel le dispositif comporte une structure pendulaire.

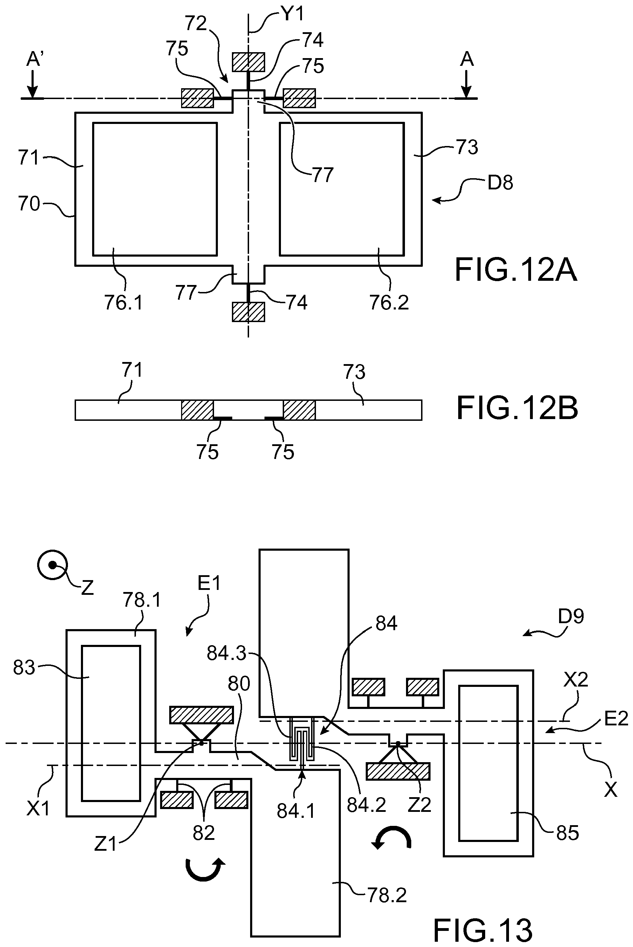

Les structures pendulaires présentent l'avantage de permettre d'obtenir facilement des modes de déplacement équilibrés et de réduire la sensibilité des modes non-équilibrés. En effet, en faisant passer l'axe de rotation par le centre d'inertie du dispositif, le centre d'inertie est rendu immobile, ce qui permet de privilégier le mode équilibré et de réduire fortement la sensibilité de la structure mécanique aux vibrations. Par exemple, ceci est obtenu en symétrisant la structure mécanique par rapport à un plan passant par l'axe de rotation. D'autres structures non-symétriques comme celles qui seront décrites sur la figure 13 présentent un centre d'inertie fixe et un mode équilibré.

Dans ce deuxième mode de réalisation, au moins deux senseurs magnétiques sont mis en œuvre. En effet, c'est le couple ou moment mécanique qui intervient dans la détection et qui est proportionnel au champ magnétique. Une comparaison des couples subis par les deux éléments mobiles portant les senseurs magnétiques distants l'un de l'autre de a permet de déterminer le gradient de champ.

Le dispositif D5 comporte un premier 50 et un deuxième 52 élément mobile reliés l'un à l'autre par une poutre rigide 54 formant une structure indéformable.

Dans un autre exemple de réalisation, la structure a la forme d'un rectangle, la poutre 54 ayant une largeur sensiblement égale celles des éléments mobiles 50 et 52.L'attache de la charnière est par exemple située dans un petit évidement au centre de la structure

La poutre rigide 52 est articulée en rotation dans le plan du substrat par une liaison pivot 56 autour de l'axe Z. De manière avantageuse les deux éléments mobiles et la poutre 54 forment une structure indéformable.

La liaison pivot 56 est semblable aux liaisons pivots de la figure 5 avec deux poutres 58 inclinées l'une par rapport à l'autre. Les poutres 58 assurent le mouvement en rotation des éléments mobiles autour de l'axe Z qui correspond au mode de déplacement équilibré et bloquent le mode de déplacement non-équilibré

Des moyens de transduction TMM sont prévus. Dans l'exemple représenté, ils sont formés par une ou des couches de matériau magnétique permanent 60, 62. Les moments magnétiques des deux couches de matériaux permanents peut être orientés selon n'importe quel axe du plan. Cependant, les moments magnétiques sur les premier et deuxième éléments mobiles ont des sens opposés.

Le couple mécanique s'écrit $\Gamma = M \wedge B$ et permet de générer des efforts aptes à mettre en rotation les premier et deuxième éléments mobiles de la structure mécanique. En présence d'un champ magnétique extérieur homogène, et du fait des orientations opposées des moments magnétiques des matériaux 60, 62, les moments mécaniques générés sur chacun des éléments mobiles sont opposés. Le couple total appliqué à l'ensemble de la structure mécanique est ainsi nul : la structure reste immobile et aucun signal n'apparaît en sortie du capteur. Si le champ possède un gradient selon l'axe X qui joint les deux masses mobiles, alors un déséquilibre dans le moment mécanique apparaît. Le couple mécanique total s'écrit, en considérant que les moments magnétiques ont des modules égaux :

$$\Gamma_{tot} = M \wedge \left( B\left( x_0 + \frac{a}{2} \right) - B\left( x_0 - \frac{a}{2} \right) \right)$$

$$\Gamma_{tot} = M \wedge \left( \frac{\partial B}{\partial x}(x_0) \right) a$$

Avec xo le centre des centres des transducteurs magnétiques et a la distance entre les centres des transducteurs magnétiques des deux éléments mobiles

Les efforts mécaniques responsables du déplacement des pièces mobiles de la structure mécanique sont de cette manière proportionnels au gradient de champ magnétique.

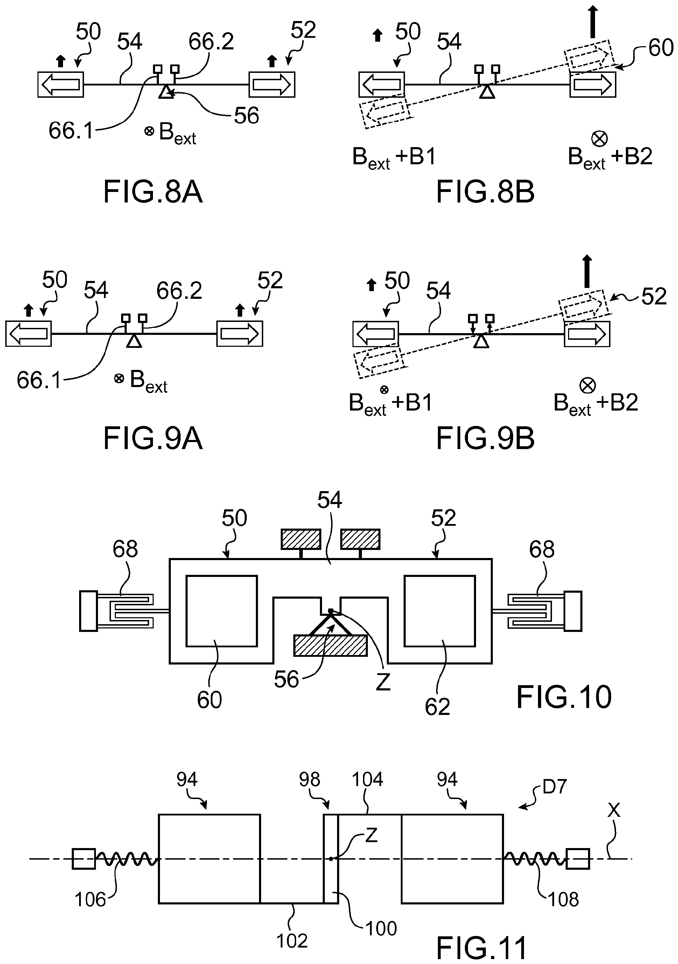

Le fonctionnement du dispositif de la figure 7 est schématisé sur les figures 8A te 8B. Les flèches correspondent aux moments magnétiques.

Sur la figure 8A, le dispositif est soumis à un champ magnétique homogène Bext. Les premier et deuxième éléments mobiles restent alignés sur l'axe X.

Sur la figure 8B, le dispositif est soumis à un gradient de champ magnétique, le premier élément mobile voit un champ Bext + B1 et le deuxième élément mobile voit un champ magnétique Bext + B2, B1 < B2. Le couple total est alors tel que la structure pivote dans le sens antihoraire.

Dans le cas où les moyens TMM comportent des conducteurs électriques sur les éléments mobiles (figures 9A et 9B), ceux-ci sont préférentiellement orientés en direction de l'axe de rotation. L'alimentation en courant des conducteurs est par exemple réalisée par des poutres de faibles raideurs transverses et en torsion s'étendant entre les éléments mobiles et le substrat.

En présence d'un champ magnétique homogène Bext, le moment mécanique généré par les forces de Laplace s'équilibre de part et d'autre de la structure mécanique (figure 9A). Lorsque la structure est soumise à un gradient de champ magnétique selon l'axe X, le premier élément voit un champ Bext + B1 et le deuxième élément voit un cham Bext +B2, alors un déséquilibre dans le moment mécanique apparait :

$$\Gamma_{tot} = \beta \frac{a}{2} e_x \wedge \left( I_x e_x \wedge B_z e_z \left( x_0 + \frac{a}{2} \right) - I_x e_x \wedge B_z e_z \left( x_0 - \frac{a}{2} \right) \right)$$

$$\Gamma_{tot} = \beta I_x \frac{\partial B_z}{\partial x}(x_0) \frac{a^2}{2} e_z$$

Avec $I_x$ le courant traversant les conducteurs 64 ; $a$ est la distance entre les centres des transducteurs magnétiques sur les deux masses mobiles ; $e_x$ est le vecteur unitaire associé à l'axe X ; $e_z$ est un vecteur unitaire associé à l'axe Z ; $\beta$ est un facteur qui résulte de l'intégration des forces sur les senseurs magnétiques et est homogène à une longueur.

Les efforts mécaniques responsables du déplacement des pièces mobiles de la structure mécanique sont proportionnels au gradient de champ magnétique.

Dans l'exemple représenté, B1<B2, et la structure pivote dans le sens antihoraire.

Des moyens de transduction mécanique-électrique TME sont également prévus. Dans l'exemple représenté, il comporte deux jauges de contraintes 66.1, 66.2 suspendues entre la poutre de connexion 54 et des plots d'ancrage.

Les jauges sont avantageusement disposées symétriquement par rapport au plan passant par l'axe Z et perpendiculaire à l'axe X. Les jauges sont par exemple des jauges piézorésistives. Chaque jauge assure une détection du déplacement d'un élément mobile et une mesure différentielle peut être effectuée. En variante, des moyens de détection capacitive peuvent être mis en œuvre. Par exemple ils comportent des peignes capacitifs solidaires de la poutre de connexion, ces peignes étant interdigités avec des peignes fixes sur le substrat de manière à réaliser une variation d'entrefer ou de surface lors d'un déplacement de la partie mobile

Sur les figures 8B et 9B, la jauge 66.1 est sollicitée en traction et la jauge 66.2 est sollicitée en compression. On mesure alors un couple différentiel proportionnel au gradient de champ magnétique.

On réalise alors une mesure différentielle permettant de déterminer le gradient de champ magnétique.

Sur la figure 10, on peut voir une variante de réalisation du dispositif de la figure 7. Le dispositif D6 dans laquelle des ressorts 68 relient les éléments mobiles au substrat, les ressorts 68 présentent des raideurs transverse et en torsion faibles afin de ne pas gêner le déplacement en rotation de la structure. Cette variante est particulièrement adaptée à la mise en œuvre de moyens TMM utilisant des conducteurs électriques, les ressorts 68 sont alors réalisés au moins en partie en matériau conducteurs électrique et peuvent servir à alimenter les conducteurs électriques. Les ressorts 68 peuvent êtres soit entièrement en matériau conducteur, soit comporter une couche continue assurant la conduction électrique.

Sur la figure 11, on peut voir un exemple de réalisation d'un dispositif D7 selon l'invention qui se rapproche à la fois du dispositif de la figure 2 et du dispositif de la figure 7. Il comporte les deux éléments mobiles 94, 96 en translation reliés par une liaison pivot 98 d'axe orthogonal au plan du substrat, l'articulation pivot 98 comporte un élément centrale 100 articulé en rotation sur le support et reliés à chacun des éléments mobiles 94, 96 par une poutre souple 102, 104. Chaque élément mobile 94, 96 est suspendu au substrat par un ressort 106, 108 autorisant le déplacement en translation le long de la direction X, mais limitant les déplacements dans les autres directions, notamment en rotation autour de l'axe Z. Cette variante présente l'avantage de rejeter mécaniquement les vibrations et l'effet du champ magnétique moyen. Du fait de la mise en œuvre d'une liaison pivot 98 entre les deux éléments mobiles 94, 96 , le mode équilibré est autorisé par les éléments mobiles qui n'admettent que des mouvements de sens opposés alors que le mode non équilibré est rejeté car il impliquerait la déformation de la pièce centrale 100 en rotation. Des moyens de détection différentielle capacitifs ou piézorésistifs tels que ceux du dispositif de la figure 2, peuvent être utilisés. Le gain de transduction Ge est alors augmenté par rapport au gain $G_{ne}$. En outre, en mettant en œuvre de moyens de transductions TME différentiel de chaque côté du centre de rotation, on peut augmenter le gain Te par rapport au gain Tne. Même si la pièce centrale se déforme, le signal dû à cette déformation est le même sur les deux jauges et est annulé à la soustraction des signaux.

Sur les figures 12A et 12B, on peut voir un autre exemple de dispositif selon le deuxième mode de réalisation.

Le dispositif D8 se distingue du dispositif D6 en ce que sa structure est mobile en rotation hors-plan. L'axe de rotation Y1 est donc contenu dans le plan du dispositif.

Le dispositif D8 comporte une plaque articulée 70 en rotation autour de l'axe Y1 au moyen d'une liaison pivot 72. Dans l'exemple représenté, la liaison pivot 72 comporte deux poutres 74 alignées avec l'axe Y1 et aptes à être déformées en torsion autour de l'axe Y1. La plaque articulée porte les deux éléments mobiles 71, 73.

Les moyens de transduction TMM comportent deux senseurs magnétiques 76.1, 76.2 disposés sur une face de la plaque 70 de part et d'autre de l'axe de rotation Y1.

Dans l'exemple représenté, les senseurs magnétiques 76.1, 76.2 comportent chacun une ou plusieurs couches de matériau magnétique permanent orientées, de sorte que les deux senseurs magnétiques aient des moments magnétiques d'orientation opposée.

Les moyens de transduction TME comportent, dans l'exemple représenté, des jauges de contrainte 75, par exemple piézorésistives, disposées perpendiculairement à l'axe de rotation et suspendues entre le substrat et la plaque de part et d'autre de l'axe de rotation Y1. Dans l'exemple représenté, la plaque comporte deux saillies latérales 77 au niveau de l'axe de rotation, une extrémité des jauges 75 étant fixée à l'une de saillie 77. La disposition des jauges par rapport à l'axe de rotation est visible sur la figure 12B, elles sont disposées dans un plan différent de celui de l'axe de rotation, de sorte que les deux jauges soient effectivement déformées lors d'une rotation de la structure.

Le fonctionnement de ce dispositif est similaire à celui du dispositif D6.

En variante, les senseurs magnétiques peuvent être réalisés par des conducteurs de courant disposés de part et d'autre de l'axe de rotation Y1. Lorsque l'on souhaite sonder le gradient de Bx, les conducteurs sont parallèles à l'axe Y, et lorsque l'on souhaite sonder le gradient de By, les lignes sont parallèles à l'axe X. Dans ces deux orientations, les forces sont orientées selon Z. Les conducteurs de courant génèrent des efforts différentiels proportionnels au gradient de champ magnétique.

En variante les moyens de transduction TME pourraient être de type capacitif, par exemple la face de la plaque en regard du substrat pourrait comporter une électrode de chaque côté de l'axe de rotation Y1 et former avec une électrode en regard sur le substrat deux condensateurs à capacité variable.

Sur la figure 13, on peut voir un autre exemple d'un dispositif de mesure de gradient de champ D9 selon le deuxième mode de réalisation.

Le système comporte une structure comprenant deux ensembles E1 et E2 couplés mécaniquement. Les deux ensembles sont de structures similaires. Seul l'ensemble E1 sera décrit en détail.

Dans cet exemple, chaque ensemble E1, E2 a au moins un mode équilibré et le dispositif a également au moins un mode équilibré. Les modes non équilibrés possèdent des raideurs élevées ou sont rejetés à des fréquences de résonance élevées pour lesquelles les vibrations mécaniques sont quasi-inexistantes.

Dans un autre exemple, le dispositif possède un mode équilibré sans que les ensembles possèdent eux-mêmes un mode équilibré. En effet, en ajustant les dimensions et les dispositions des deux ensembles, on peut réaliser une structure possédant un mode équilibré. Par rapport aux structures E1 et E2 de la figure 13, on peut envisager de supprimer l'une des éléments mobiles de chaque ensemble. Dans ce cas, chacune de ces structures des ensembles E1 et E2 n'est pas équilibrée, mais la structure comportant les deux ensembles connectés comme sur la figure 13 présente un mode équilibré, par exemple en ajustant les dimensions de la structure.

L'effet des vibrations sur le dispositif D9 est rejeté au niveau de chaque ensemble E1, E2 du fait de sa faible sensibilité au mode non équilibré. L'effet du champ magnétique moyen est rejeté au niveau du dispositif D9 comme cela sera expliqué ci-dessous.

L'ensemble E1 est mobile en rotation autour d'un axe Z1 orthogonal au plan du dispositif, il comporte deux éléments mobiles 78.1, 78.2 reliés par une poutre de liaison 80. Des jauges de contraintes 82 permettent de mesurer le déplacement différentiel de la structure autour de l'axe Z. L'ensemble E1 ne présente pas de plan de symétrie passant par l'axe de rotation, mais présente néanmoins un mode équilibré. En variante, l'ensemble E1 pourrait être symétrique par rapport à l'axe de rotation.

En effet, en considérant que la poutre de liaison 80 s'étend le long d'un axe X1, le premier élément mobile 78.1 s'étend perpendiculairement à l'axe X1 d'un côté de celui-ci et le deuxième élément mobile 78.2 s'étend perpendiculairement à l'axe X1, mais du côté opposé à celui du côté duquel s'étend le premier élément mobile 78.1.

Dans cet exemple, l'ensemble E2 est disposé à côté de l'ensemble E1 de sorte que la poutre de liaison, entre les deux éléments mobiles de l'ensemble E2, s'étende le long d'un axe X2 parallèle et distinct de l'axe X1 et, de sorte que le deuxième élément mobile 78.2 soit aligné avec le deuxième élément mobile de l'ensemble E2 le long de l'axe Y.

Il sera compris que les dispositions relatives des ensembles E1 et E2 peut varier, par exemple les axes X1 et X2 pourraient être confondus, ou les axes X1 et X2 pourraient ne pas être parallèles; les deux deuxièmes éléments pourraient ne pas être alignés

Dans l'exemple représenté, l'intersection des axes de rotation avec le plan du système sont disposés le long de l'axe X.

Un senseur magnétique 83, 85 est prévu pour chaque ensemble E1, E2 sur le premier élément mobile de l'ensemble E1 et sur le second élément mobile de E2. Ils peuvent être formés soit par un matériau magnétique permanent, soit par des conducteurs électriques.

Dans le dispositif de la figure 13, les deux éléments mobiles de chaque ensemble servent à réaliser un dispositif ayant au moins un mode équilibré, mais ils ne sont pas destinés à porter tous les deux des senseurs magnétiques. La transduction magnétique-mécanique se fait au niveau du dispositif dans son ensemble.

Le dispositif comporte des moyens de liaison mécanique déformables 84 entre les ensembles E1, E2 tels qu'ils autorisent des mouvements de rotation des structures des ensembles E1, E2 en sens opposés et qui bloquent les rotations dans le même sens.

Les moyens de liaison mécanique 84 relient mécaniquement deux éléments mobiles de E1 et E2. Dans l'exemple représenté, les moyens de liaison 84 sont, par exemple, formés par des lames repliées formant une sorte de fourche comportant une portion centrale 84.1 reliée à l'ensemble E1 et deux portions latérales 84.2, 84.3 reliées à l'ensemble E2. D'autres formes de moyens de liaison 84 sont envisageables, par exemple une poutre reliant les deux éléments mobiles.

De manière avantageuse et comme cela est représenté sur la figure 12, la direction de raideur maximale des moyens de liaison 84 est perpendiculaire au plan défini par les deux axes de rotation parallèles des deux structures pendulaires.

Les deux ensembles E1, E2 ont un mode mécanique équilibré et sont peu sensibles aux vibrations.

La structure mécanique ainsi formée présente des raideurs longitudinales selon l'axe Y importante et selon l'axe X faible. La raideur en torsion autour de l'axe Z est également faible ou équivalente en comparaison avec les raideurs en torsion des liaisons pivots de chaque dispositif.

De manière avantageuse, les moyens de liaison 84 entre les deux ensembles se situent au voisinage du plan défini par les deux axes de rotation Z1, Z2. Les déplacements en translation de la structure selon les axes perpendiculaires aux axes de rotation sont réduits de manière sensible. En effet, les déplacements le long des axes perpendiculaires aux axes de rotation induisent un effort de rappel qui s'oppose aux mouvements de rotation contraires des deux dispositifs.

Dans le cas de senseurs magnétique à matériau magnétique permanent, les moments magnétiques des deux senseurs magnétiques sont parallèles et de même sens afin de générer un couple mécanique mettant en rotation les deux dispositifs en sens opposé, contrairement au dispositif D6 dans lequel les moments magnétiques des deux matériaux ont des orientations opposées. Cette réalisation est avantageuse du point de vue de la fabrication, car la réalisation de senseurs magnétiques sur une même structure ayant des moments magnétiques orientés dans le même sens est plus simple à obtenir que des senseurs magnétiques ayant des moments magnétiques de sens opposés.

Dans l'exemple représenté, les matériaux sont disposés sur les deux premiers éléments mobiles, mais ils pourraient être disposés sur toute autre partie des ensembles. Par exemple, le senseur magnétique 83 pourrait être formé sur le deuxième élément mobile de l'ensemble E1. Mais, de préférence, les senseurs magnétique sont réalisés de sorte à être le plus éloignés possible l'un de l'autre, comme cela est réalisé dans le dispositif de la figure 13, de sorte à accroître l'effet du gradient de champ.

Les moments mécaniques générés par les senseurs magnétiques produisent avec l'aide de l'élément de liaison 84 une rotation des structures E1 et E2 des angles $\theta_1$ et $\theta_2 = -L_1\theta_1/L_2$ qui est proportionnelle à la force généralisée :

$$F_l = \frac{M_{c1}}{L_1} - \frac{M_{c2}}{L_2}$$

avec $L_i$ la distance entre l'élément de liaison et le pivot de chaque ensemble, $M_{c1}$ et $M_{c2}$ les moments mécaniques générés par les senseurs magnétiques. Pour simplifier, on considère ici le cas ou $L_1$ et $L_2$ sont identiques.

Les efforts mécaniques s'appliquant sur les deux ensembles s'opposent au niveau des moyens de liaison 84. En présence d'un champ magnétique homogène, les moments magnétiques génèrent des moments mécaniques qui se compensent : les deux ensembles bloquent mutuellement leur mouvement. Aucun signal n'est généré en sortie du capteur. Dans le cas général, les moments magnétiques et les distances au pivot peuvent être ajustés afin de vérifier de manière préférentielle la relation $\frac{M_1}{L_1} = \frac{M_2}{L_2}$.

En présence d'un gradient de champ magnétique selon l'axe X, un différentiel de moment mécanique apparaît entre les deux ensembles. La différence de moment mécanique, qui est proportionnelle au gradient de champ magnétique, résulte en un effort non nul sur chaque ensemble. Des mouvements de rotation opposés sont ainsi produits sur les deux ensembles, qui peuvent être mesurés par les moyens de transduction électromécaniques et permettent de fournir le signal de mesure du capteur.

Dans le cas de senseurs magnétiques formés par des conducteurs électriques, les conducteurs électriques d'un senseur magnétique sont préférentiellement orientés en direction de l'axe de rotation du dispositif auquel ils appartiennent. La structure est alors sensible principalement au gradient de champ de la composante $B_z$.

Le choix du sens du courant traversant les conducteurs électrique dépend de la disposition des conducteurs électriques dans les dispositifs, de sorte que les dispositifs soient effectivement mis en rotation dans des sens opposés en présence d'un gradient de champ et restent immobiles en présence d'un champ homogène

Dans le cas où les deux senseurs magnétiques sont soit tous les deux réalisés sur les éléments mobiles les plus à l'extérieur du système (figure 13), soit sur les éléments mobiles les plus à l'intérieur du système, les sens des courants de Laplace sont dans des sens opposés.

Pour d'autres cas, les courants pourraient également avoir le même sens.

Comme pour les senseurs à matériau magnétique permanent, en présence de champ magnétique homogène, les efforts mécaniques se compensent, les deux ensembles sont immobiles et aucun signal de mesure n'est généré. En présence d'un gradient de champ magnétique selon l'axe X, des efforts proportionnels au gradient de champ sont produits et mettent en mouvement chacun des ensembles dont le déplacement en rotation est mesuré par les jauges.

Sur la figure 14, on peut voir un autre exemple de dispositif D10 mettant en œuvre deux ensembles ayant des déplacements en rotation hors-plan.

Le dispositif D10 de la figure 14 combine deux ensembles de structure proche du dispositif de la figure 12.

Les deux ensembles E3, E4 sont mobiles en rotation hors-plan autour des axes Y1 et Y2 respectivement. Les ensembles E3 et E4 sont alignés l'un à côté de l'autre le long de l'axe X et articulés l'un par rapport à l'autre par une liaison pivot 86 d'axe Y.

Deux bords d'extrémité longitudinale 88, 89 des deux ensembles E3, E4 sont en regard

Dans l'exemple représenté, la liaison pivot 86 comporte deux poutres 90 alignées le long de l'axe Y et déformables en torsion autour de l'axe Y. Chaque poutre 90 est suspendue entre les deux ensembles E3, E4.

Lorsque les deux ensembles E3, E4 pivotent, les bords d'extrémité longitudinale 88, 89 se déplacent dans le même sens vers le substrat ou en éloignement du substrat.

Chaque ensemble comporte un senseur magnétique 92.

Dans le cas de senseurs magnétiques en matériau magnétique permanent, les moments magnétiques des deux senseurs magnétiques sont parallèles et de même sens. Comme pour le dispositif de la figure 13, les couches magnétiques peuvent être déposées sur n'importe quelle zone des ensembles E3, E4.

En présence d'un champ magnétique homogène, les moments magnétiques génèrent des moments mécaniques qui se compensent : les deux ensembles E3, E4 bloquent mutuellement leur mouvement. Aucun signal n'est généré en sortie du capteur. En présence d'un gradient de champ magnétique selon l'axe X, un différentiel de moment mécanique apparaît entre les deux ensembles E3, E4. La différence entre les moments mécaniques est proportionnelle au gradient de champ magnétique, il en résulte un effort non nul sur chaque ensemble. Des mouvements de rotation opposés sont ainsi produits sur les deux ensembles qui sont détectés par les moyens de transduction électromécaniques qui fournissent le signal de mesure du capteur.

Dans le cas de senseurs magnétiques formés par des conducteurs de courant, contrairement au dispositif de la figure 13, les conducteurs électriques peuvent être orientés parallèlement aux axes de rotation de chaque dispositif. La direction des conducteurs de courant permet de sélectionner la composante de gradient de champ Bx ou $B_Y$ que l'on veut mesurer. Les conducteurs sont orientés selon la direction X pour mesurer $B_Y$ et sont orientés dans la direction Y pour mesure Bx.

Dans le cas où les senseurs magnétiques ne sont pas disposés symétriquement par rapport à l'axe Y, les sens des courants de Laplace peuvent être identiques. Dans ces conditions ils génèrent des moments mécaniques de même signe sur les ensembles E3 et E4.

Si les senseurs magnétiques sont disposés symétriquement par rapport à l'axe Y comme c'est le cas sur la figure 14, les courants de Laplace circulent en sens opposés. En présence d'un champ magnétique homogène, les efforts mécaniques se compensent. En présence d'un gradient de champ magnétique selon l'axe X, des efforts proportionnels à ce dernier sont produits et mettent en mouvement la structure mécanique. Le mouvement en rotation de chacun des ensembles peut être mesuré et fournir un signal portant sur le gradient de champ magnétique.

L'un des avantages des structures des figures 13 et 14 réside dans l'orientation des moments magnétiques des senseurs magnétiques mis en œuvre. Dans ces structures les moments magnétiques sont de même sens : ceci permet de simplifier sensiblement, la réalisation technologique. En effet, l'obtention de moments magnétiques opposés nécessite souvent des méthodes de magnétisation locale telles que l'aimantation sous échauffement laser localisé par exemple, et non collective à l'échelle du substrat.

Un mode de mesure hétérodyne peut également être appliqué. Ceci s'applique dans le cas où les senseurs magnétiques sont constitués de conducteur électrique dans lequel un courant peut être injecté. Le courant est modulé à une fréquence $f_p$, ce qui décale de la même quantité le spectre du signal de gradient de champ. Ceci permet de séparer d'une part le spectre fréquentiel du gradient de champ de celui des vibrations qui se situent en général en dessous de 20 kHz pour de nombreuses applications. D'autre part, en positionnant la fréquence $f_p$ au voisinage de la fréquence de résonance du mode équilibré, il est possible d'amplifier le signal d'intérêt, i.e. le signal de gradient de champ, d'un facteur pouvant aller jusqu'au facteur de qualité du mode équilibré. Le mouvement selon le mode non équilibré est quant à lui maintenu faible, car sa fréquence de résonance est conçue préférentiellement pour être en dehors du spectre des vibrations. Il en résulte une réjection des signaux parasites accrue.

Le dispositif de mesure d'un gradient selon l'invention peut être très avantageusement réalisé par des techniques de la microélectronique. Ainsi il présente les avantages des magnétomètres microélectromécaniques ou MEMS (Microelectromechanical Systems en terminologie anglo-saxonne) en termes de coût, de sensibilité, de basse consommation et de miniaturisation et s'affranchit des champs magnétiques perturbateurs.

En outre, grâce à la mise en œuvre d'une structure ayant au moins un mode d'actionnement équilibré, le dispositif est peu ou pas sensible aux vibrations, il peut alors être utilisé pour détecter un gradient de champ magnétique dans des capteurs de position/vitesse/courant notamment pour le domaine automobile

Les structures mécaniques décrites dans les figures 2, 4, 5 et 6 possèdent des modes de déplacement nonéquilibrés mais ayant des sensibilités aux vibrations réduites. En outre, les modes non-équilibrés sont généralement repoussés à hautes fréquences, en dehors de la bande passante des vibrations auxquelles peut être soumis le capteur.

Le capteur de gradient de champ magnétique peut être utilisé par exemple dans la détection de position angulaire d'arbre à came dans un moteur à combustion ou pour réaliser des détecteurs de mouvement de proximité.

**Revendications**

1. Capteur de gradient de champ magnétique comportant un support et une structure comportant au moins un premier (2) et un deuxième (4) élément mobile, des moyens de couplage (12, 24) entre le premier élément mobile (2) et le deuxième élément mobile (4), de manière à ce que la structure puisse être déplacée selon au moins un mode mécanique équilibré en présence d'un gradient de champ magnétique, ledit capteur comportant également des moyens de transduction magnétique mécanique (TMM) comportant au moins un senseur magnétique (11) solidaire mécaniquement d'un des premier (2) et deuxième (4) éléments mobiles, de sorte à pouvoir appliquer un effort mécanique à la structure en présence d'un gradient de champ magnétique, et des moyens de transduction électromécanique (TME) comportant des moyens de mesure du déplacement (14, 16) de la structure au moins pour le mode équilibré, **caractérisé en ce que** les moyens de transduction magnétique mécanique (TMM) sont configurés pour présenter un gain de transduction magnétique-mécanique supérieur pour les mouvements dans le mode équilibré que pour les mouvements dans le mode non équilibré, et/ou les moyens de transduction électromécanique (TME) sont configurés pour présenter un gain électromécanique supérieur pour les mouvements dans le mode équilibré que pour les mouvements dans le mode non équilibré.

2.  Capteur de gradient de champ magnétique selon la revendication 1, comportant au moins deux senseurs magnétiques (11,13), chacun des senseurs magnétiques (11,13 ) étant solidaire mécaniquement d'un des premier (2) et deuxième (4) éléments mobiles, de sorte à pouvoir appliquer un effort mécanique à la structure en présence d'un gradient de champ magnétique, des moyens de couplage (12, 24) entre le premier élément mobile (2) et le deuxième élément mobile (4), de manière à ce que la structure puisse être déplacée selon au moins un mode mécanique équilibré en présence d'un gradient de champ magnétique, et des moyens de mesure (14, 16) du déplacement de la structure au moins pour le mode équilibré.

3.  Capteur de gradient de champ magnétique selon la revendication 1 ou 2, dans lequel les moyens de couplage mécanique (12, 24) sont tels qu'ils autorisent un déplacement en translation du premier élément mobile (2) et du deuxième élément mobile (4) l'un par rapport à l'autre le long d'une première direction donnée (X) au moins en sens opposé, correspondant au mode mécanique équilibré, ledit premier élément mobile (25) et ledit deuxième élément mobile (4) se déplaçant en translation dans le même plan, les moyens de couplage mécanique (24) étant également avantageusement solidaires de deux autres éléments mobiles (28, 30, 42, 44) en translation selon une direction (Y) orthogonale à la première direction (X) et empêchant le déplacement en phase des premier (2) et deuxième (4) éléments mobiles, correspondant à un mode mécanique non-équilibré.

4.  Capteur de gradient de champ magnétique selon la revendication 3, dans lequel les moyens de couplage mécanique (12, 24) comportent un ressort, par exemple en forme de losange, les premier et deuxième éléments mobiles (2, 4) étant reliés chacun à un sommet (S1, S3) du losange, les sommets étant opposés.

5.  Capteur de gradient de champ magnétique selon la revendication 2, dans lequel les moyens de couplage mécanique forment une articulation pivot de la structure sur le support, avantageusement les moyens de couplage mécanique reliant rigidement le premier élément mobile (2) et le deuxième élément mobile (4).

6.  Capteur de gradient de champ magnétique selon l'une des revendications 1 à 5, dans lequel les moyens de mesure (14, 16) du déplacement de la structure en mode équilibré sont des moyens capacitifs, avantageusement les moyens de mesure du déplacement de la structure en mode équilibré (14, 16) comportant au moins deux peignes capacitifs, un peigne (14.1, 16.1) étant solidaire d'un élément mobile (2, 4) et un peigne (14.2, 16.2) est solidaire du support, et les peignes paires étant connectés électriquement en parallèle.

7.  Capteur de gradient de champ magnétique selon l'une des revendications 1 à 6, dans lequel les moyens de mesure du déplacement de la structure en mode équilibré comportent au moins une jauge de contrainte (16') suspendue entre le support et les moyens de couplage (12).

8.  Capteur de gradient de champ magnétique selon la revendication 1 ou 2, comportant deux ensembles (E1, E2), chaque ensemble (E1, E2) comportant le premier ou le deuxième élément mobile, les moyens de couplage mécanique reliant les deux ensembles, dans lequel chaque ensemble (E1, E2) ayant avantageusement un mode équilibré.

9.  Capteur de gradient de champ magnétique selon les revendications 2 et 8, dans lequel chaque ensemble (E1,E2) est articulé en rotation sur le support autour d'un axe de rotation, les deux axe de rotation des deux ensembles étant parallèles, les moyens de couplage étant tels qu'ils autorisent les mouvement de rotation des deux ensembles (E1, E2) en sens opposés et empêchent les mouvements de rotation des deux ensembles (E1,E2) dans le même sens.

10. Capteur de gradient de champ magnétique selon l'une des revendications 1 à 9, dans lequel chaque senseur magnétique (11, 13) comporte au moins un matériau magnétique permanent déposé sur au moins un élément mobile.

11. Capteur de gradient de champ magnétique selon l'une des revendications 1 à 8 en combinaison avec les revendications 2 et 10, dans lequel les deux senseurs magnétiques (11, 13) ont des moments magnétiques d'orientation opposée.

**12.** Capteur de gradient de champ magnétique selon les revendications 2, 9 et 10, dans lequel les deux senseurs magnétiques ont des moments magnétiques de même orientation.

**13.** Capteur de gradient de champ magnétique selon l'une des revendications 1 à 9, dans lequel chaque senseur magnétique comporte au moins un conducteur électrique (20) destiné à être traversé par un courant électrique, le courant électrique étant avantageusement modulé à la fréquence de résonance du mode équilibré, et le capteur de gradient de champ magnétique comportant avantageusement des éléments conducteurs électriques souples (68) reliant les éléments mobiles à des plots de contact ancrés sur le support.

**14.** Capteur de gradient de champ magnétique selon la revendication 13, dans lequel le au moins un conducteur électrique s'étend dans une direction telle que les forces de Laplace générées mettent en mouvement la structure du dispositif.

**15.** Capteur de gradient de champ magnétique selon la revendication 13 en combinaison avec les revendications 5, 6, 8 et 9, dans lequel le au moins un conducteur électrique est orienté en direction de l'axe de rotation de la liaison pivot formée par les moyens de couplage mécanique.

**Patentansprüche**

**1.** Magnetfeldgradientensensor, umfassend einen Träger und eine Struktur, die wenigstens ein erstes (2) und ein zweites (4) bewegliches Element umfasst, Kopplungsmittel (12, 24) zwischen dem ersten beweglichen Element (2) und dem zweiten beweglichen Element (4) derart, dass die Struktur gemäß wenigstens einem mechanischen Gleichgewichtsmodus in Anwesenheit eines Magnetfeldgradienten verlagert werden kann, wobei der Sensor ferner magnetisch-mechanische Transduktionsmittel (TMM) umfasst, die wenigstens einen magnetischen Sensor (11) umfassen, der mechanisch mit einem von dem ersten (2) und dem zweiten (4) beweglichen Element verbunden ist, derart, dass in Anwesenheit eines Magnetfeldgradienten eine mechanische Kraft auf die Struktur ausgeübt werden kann, und elektromechanische Transduktionsmittel (TME), die Mittel zum Messen der Verlagerung (14, 16) der Struktur wenigstens für den Gleichgewichtsmodus umfassen, **dadurch gekennzeichnet, dass** die magnetischmechanischen Transduktionsmittel (TMM) dazu konfiguriert sind, eine größere magnetisch-mechanische Transduktionsverstärkung für die Bewegungen im Gleichgewichtsmodus als für die Bewegungen im Nichtgleichgewichtsmodus aufzuweisen, und/oder die elektromechanischen Transduktionsmittel (TME) dazu konfiguriert sind, eine größere elektromechanische Verstärkung für die Bewegungen im Gleichgewichtsmodus als für die Bewegungen im Nichtgleichgewichtsmodus aufzuweisen.

**2.** Magnetfeldgradientensensor nach Anspruch 1, umfassend wenigstens zwei magnetische Sensoren (11, 13), wobei jeder der magnetischen Sensoren (11, 13) mechanisch mit einem von dem ersten (2) und dem zweiten (4) beweglichen Element verbunden ist, derart, dass in Anwesenheit eines Magnetfeldgradienten eine mechanische Kraft auf die Struktur ausgeübt werden kann, Kopplungsmittel (12, 14) zwischen dem ersten beweglichen Element (2) und dem zweiten beweglichen Element (4) derart, dass die Struktur in Anwesenheit eines Magnetfeldgradienten gemäß wenigstens einem mechanischen Gleichgewichtsmodus verlagert werden kann, und Mittel (14, 16) zum Messen der Verlagerung der Struktur wenigstens für den Gleichgewichtsmodus.

**3.** Magnetfeldgradientensensor nach Anspruch 1 oder 2, bei dem die mechanischen Kopplungsmittel (12, 24) derart sind, dass sie eine Translationsverlagerung des ersten beweglichen Elements (2) und des zweiten beweglichen Elements (4) relativ zueinander entlang einer ersten gegebenen Richtung (X) wenigstens in entgegengesetzter Richtung entsprechend dem mechanischen Gleichgewichtsmodus ermöglichen, wobei sich das erste bewegliche Element (25) und das zweite bewegliche Element (4) in Translation in der gleichen Ebene verlagern, wobei die mechanischen Kopplungsmittel (24) ebenfalls vorzugsweise mit zwei anderen beweglichen Elementen (28, 30, 42, 44) in Translation entlang einer Richtung (Y) orthogonal zur ersten Richtung (X) verbunden sind und die Verlagerung des ersten (2) und des zweiten (4) beweglichen Elements in Phase verhindern, entsprechend einem mechanischen Nichtgleichgewichtsmodus.

**4.** Magnetfeldgradientensensor nach Anspruch 3, bei dem die mechanischen Kopplungsmittel (12, 24) eine Feder umfassen, beispielsweise in Rautenform, wobei das erste und das zweite bewegliche Element (2, 4) jeweils mit einer Spitze (S1, S3) der Raute verbunden sind, wobei die Spitzen entgegengesetzt sind.

**5.** Magnetfeldgradientensensor nach Anspruch 2, bei dem die mechanischen Kopplungsmittel ein Schwenkgelenk der Struktur auf dem Träger bilden, wobei vorzugsweise die mechanischen Kopplungsmittel das erste bewegliche Element (2) und das zweite bewegliche Element (4) starr verbinden.

6. Magnetfeldgradientensensor nach einem der Ansprüche 1 bis 5, bei dem die Mittel (14, 16) zum Messen der Verlagerung der Struktur im Gleichgewichtsmodus kapazitive Mittel sind, wobei vorzugsweise die Mittel zum Messen der Verlagerung der Struktur im Gleichgewichtsmodus (14, 16) wenigstens zwei kapazitive Kämme umfassen, wobei ein Kamm (14.1, 16.1) mit einem beweglichen Element (2, 4) verbunden ist, und ein Kamm (14.2, 16.2) mit dem Träger verbunden ist, und die paarigen Kämme elektrisch parallel verbunden sind.

7. Magnetfeldgradientensensor nach einem der Ansprüche 1 bis 6, bei dem die Mittel zum Messen der Verlagerung der Struktur im Gleichgewichtsmodus wenigstens einen Dehnungsmessstreifen (16') umfassen, der zwischen dem Träger und den Kopplungsmitteln (12) aufgehängt ist.

8. Magnetfeldgradientensensor nach Anspruch 1 oder 2, der zwei Anordnungen (E1, E2) umfasst, wobei jede Anordnung (E1, E2) das erste oder das zweite bewegliche Element umfasst, wobei die mechanischen Kopplungsmittel die zwei Anordnungen verbinden, wobei jede Anordnung (E1, E2) vorzugsweise einen Gleichgewichtsmodus hat.

9. Magnetfeldgradientensensor nach den Ansprüchen 2 und 8, bei dem jede Anordnung (E1, E2) rotatorisch an dem Träger um eine Rotationsachse angelenkt ist, wobei die zwei Rotationsachsen der zwei Anordnungen parallel sind, wobei die Kopplungsmittel derart sind, dass sie die Rotationsbewegung der zwei Anordnungen (E1, E2) in entgegengesetzten Richtungen ermöglichen und die Rotationsbewegungen der zwei Anordnungen (E1, E2) in der gleichen Richtung verhindern.

10. Magnetfeldgradientensensor nach einem der Ansprüche 1 bis 9, bei dem jeder magnetische Sensor (11, 13) wenigstens ein Permanentmagnetmaterial umfasst, das auf wenigstens ein bewegliches Element aufgebracht ist.

11. Magnetfeldgradientensensor nach einem der Ansprüche 1 bis 8 in Kombination mit den Ansprüchen 2 und 10, bei dem die zwei magnetischen Sensoren (11, 13) magnetische Momente mit entgegengesetzter Orientierung haben.

12. Magnetfeldgradientensensor nach den Ansprüchen 2, 9 und 10, bei dem die zwei magnetischen Sensoren magnetische Momente mit gleicher Orientierung haben.

13. Magnetfeldgradientensensor nach einem der Ansprüche 1 bis 9, bei dem jeder magnetische Sensor wenigstens einen elektrischen Leiter (20) umfasst, der dazu ausgelegt ist, von einem elektrischen Strom durchsetzt zu werden, wobei der elektrische Strom vorzugsweise mit der Resonanzfrequenz des Gleichgewichtsmodus moduliert ist, und wobei der Magnetfeldgradientensensor vorzugsweise flexible elektrische Leitungselemente (68) umfasst, die die beweglichen Elemente mit Kontaktpunkten verbinden, die an dem Träger angebracht sind.

14. Magnetfeldgradientensensor nach Anspruch 13, bei dem der wenigstens eine elektrische Leiter sich in einer derartigen Richtung erstreckt, dass die erzeugten Laplacekräfte die Struktur der Vorrichtung in Bewegung versetzen.

15. Magnetfeldgradientensensor nach Anspruch 13 in Kombination mit den Ansprüchen 5, 6, 8 und 9, bei dem der wenigstens eine elektrische Leiter in Richtung der Rotationsachse der Schwenkverbindung orientiert ist, die durch die mechanischen Kopplungsmittel gebildet ist.

**Claims**

1. A magnetic field gradient sensor including a support and a structure including at least one first (2) and one second (4) movable elements, coupling means (12, 24) between the first movable element (2) and the second movable element (4), such that the structure can be displaced according to at least one balanced mechanical mode in the presence of a magnetic field gradient, said sensor also including magnetic mechanical transduction (TMM) means including at least one magnetic sensor (11) mechanically secured to one of the first (2) and second (4) movable elements, so as to be able to apply a mechanical load to the structure in the presence of a magnetic field gradient, and electromechanical transduction (TME) means including structure displacement measurement means (14, 16) at least for the balanced mode, **characterized in that** the magnetic mechanical transduction means (TMM) are configured to have a higher magnetic-mechanical transduction gain for movements in the balanced mode than for movements in the unbalanced mode, and/or the electromechanical transduction (TME) means are configured to have a higher electromechanical gain for movements in the balanced mode than for movements in the unbalanced mode.

2. The magnetic field gradient sensor according to claim 1, including at least two magnetic sensors (11,13), each of the magnetic sensors (11,13) being mechanically secured to one of the first (2) and second (4) movable elements, so as to be able to apply a mechanical load to the structure in the presence of a magnetic field gradient, coupling means (12, 24) between the first movable element (2) and the second movable element (4), such that the structure can be displaced according to at least one balanced mechanical mode in the presence of a magnetic field gradient, and structure displacement measurement means (14, 16) at least for the balanced mode.

3. The magnetic field gradient sensor according to claim 1 or 2, wherein the mechanical coupling means (12, 24) are such that they allow translational displacement of the first movable element (2) and second movable element (4) with respect to each other along a first given direction (X) at least in an opposite sense, corresponding to the balanced mechanical mode, said first movable element (25) and said second movable element (4) being translationally displaced in the same plane, the mechanical coupling means (24) being also advantageously secured to two other movable elements (28, 30, 42, 44) translationally movable along a direction (Y) orthogonal to the first direction (X) and prohibit displacement in phase of the first (2) and second (4) movable elements, corresponding to an unbalanced mechanical mode.

4. The magnetic field gradient sensor according to claim 3, wherein the mechanical coupling means (12, 24) include a spring, for example a rhombus-shaped spring, the first and second movable elements (2, 4) being each connected to an apex (S1, S3) of the rhombus, the apexes being opposite to each other.

5. The magnetic field gradient sensor according to claim 2, wherein the mechanical coupling means form a pivot connection of the structure to the support, advantageously the mechanical coupling means rigidly connecting the first movable element (2) and the second movable element (4).

6. The magnetic field gradient sensor according to one of claims 1 to 5, wherein the structure displacement measurement means (14, 16) in the balanced mode are capacitive means, advantageously the structure displacement measurement means (14, 16) in balanced mode including at least two capacitive combs, one comb (14.1, 16.1) being secured to a movable element (2, 4) and one comb (14.2, 16.2) is secured to the support, and wherein the even combs are electrically connected in parallel.

7. The magnetic field gradient sensor according to one of claims 1 to 6, wherein the structure displacement measurement means in balanced mode include at least one strain gauge (16') suspended between the support and the coupling means (12).

8. The magnetic field gradient sensor according to claim 1 or 2, including two assemblies (E1, E2), each assembly (E1, E2) including the first or the second movable element, the mechanical coupling means connecting both assemblies, wherein each assembly (E1, E2) having advantageously a balanced mode.

9. The magnetic field gradient sensor according to claims 2 and 8, wherein each assembly (E1, E2) is rotatably hinged to the support about an axis of rotation, both axes of rotation of both assemblies being parallel to each other, the coupling means being such that they allow rotational movements of both assemblies (E1, E2) in opposite senses and prohibit rotational movements of both assemblies (E1, E2) in the same sense.

10. The magnetic field gradient sensor according to one of claims 1 to 9, wherein each magnetic sensor (11, 13) includes at least one permanent magnetic material deposited on at least one movable element.

11. The magnetic field gradient sensor according to one of claims 1 to 8 in combination with claims 2 and 10, wherein both magnetic sensors (11, 13) have magnetic moments with an opposite orientation.

12. The magnetic field gradient sensor according to claims 2, 9 and 10, wherein both magnetic sensors have magnetic moments with a same orientation.

13. The magnetic field gradient sensor according to one of claims 1 to 9, wherein each magnetic sensor includes at least one electric conductor (20) for an electric current to pass therethrough, the electric current being advantageously modulated at the resonant frequency of the balanced mode, and the magnetic filed gradient sensor advantageously comprising a flexible electrically conducting elements (68) connecting the movable elements to contact studs secured to the support.

14. The magnetic field gradient sensor according to claim 13, wherein the at least one electric conductor extends in a direction such that Laplace forces generated move the structure of the device.

15. The magnetic field gradient sensor according to claim 13 in combination with claims 5, 6, 8 and 9, wherein the at least one electric conductor is oriented toward the axis of rotation of the pivot connection formed by the mechanical coupling means.

$\nabla B$ → | TMM | → | TME | → | CSE | → S

## FIG.1

## FIG.2

$$F_x \qquad M \qquad B$$

$$\frac{\partial B_y}{\partial x}$$

## FIG.3

FIG.4

FIG.5

FIG.6

FIG.7

FIG.8A

FIG.8B

FIG.9A

FIG.9B

FIG.10

FIG.11

FIG.12A

FIG.12B

FIG.13

FIG.14

FIG.15

**EP 3 707 522 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- US 20070096729 A
- WO 2015058229 A
- US 2012176129 A
- US 20110151589 A